# EUROPEAN PATENT APPLICATION

(11) **EP 4 737 462 A1**
(43) Date of publication of application: **06.05.2026**
(21) Application number: 24849684.6
(22) Date of filing: 30.07.2024
(51) Int. Cl.: C07F 7/08, C07F 7/30, H10K 85/40, H10K 85/60, H10K 85/30

(54) **ORGANIC COMPOUND AND ORGANIC LIGHT-EMITTING DEVICE COMPRISING SAME**

(30) Priority: 31.07.2023 KR 20230099961
(71) Applicant: SFC Co., Ltd., Cheongju-si, Chungcheongbuk-do 28122 (KR)
(72) Inventor: KIM, Kyeong-hyeon, Cheongju-si, Chungcheongbuk-do 28122 (KR); KIM, Ji-yung, Cheongju-si, Chungcheongbuk-do 28122 (KR); KIM, Si-in, Cheongju-si, Chungcheongbuk-do 28122 (KR); JANG, Hyuk-woo, Cheongju-si, Chungcheongbuk-do 28122 (KR); CHOI, Do-yeong, Cheongju-si, Chungcheongbuk-do 28122 (KR); PARK, Seo-youn, Cheongju-si, Chungcheongbuk-do 28122 (KR); CHOI, Yeon-jae, Cheongju-si, Chungcheongbuk-do 28122 (KR); KIM, Kyeong-wan, Cheongju-si, Chungcheongbuk-do 28122 (KR); LEE, Se-jin, Cheongju-si, Chungcheongbuk-do 28122 (KR)
(74) Representative: Grosse, Felix Christopher
(86) International application number: PCT/KR2024/095942
(87) International publication number: WO 2025/029117

(57) **Abstract**

The present invention relates to an organic light-emitting device including a plurality of host compounds in a light-emitting layer and employing a compound having a characteristic structure as one host material, thereby enabling low-voltage driving, and achieving significantly improved light-emitting efficiency and lifespan, resulting in high efficiency and long lifespan properties. Accordingly, the organic light-emitting device may be industrially utilized not only in lighting devices, but also in various display devices such as flat-panel, flexible and wearable displays, displays for vehicles or aviation, and displays for virtual or augmented reality.

## Description

### [Technical Field]

The present invention relates to an organic compound employed in a light-emitting layer in an organic light-emitting device, and an organic light-emitting device including the same.

### [Background Art]

Organic light-emitting devices are self-luminous devices in which electrons injected from an electron injecting electrode (cathode) combine with holes injected from a hole injecting electrode (anode) in a light-emitting layer to form excitons, which emit light while releasing energy. Such organic light-emitting devices have advantages of low driving voltage, high luminance, wide viewing angle and short response time, and being applicable to full-color light-emitting flat-panel displays. Due to these advantages, organic light-emitting devices have received attention as next-generation light sources.

The above characteristics of organic light-emitting devices are achieved by structural optimization of organic layers of the devices and are supported by stable and efficient materials for the organic layers, such as hole injecting materials, hole transport materials, hole blocking materials, light-emitting materials, electron transport materials, electron injecting materials, and electron blocking materials. However, more research still needs to be done to develop structurally optimized structures of organic layers for organic light-emitting devices and stable and efficient materials for organic layers of organic light-emitting devices.

Particularly, to obtain maximum efficiency in a light-emitting layer, an appropriate combination of energy band gaps of a host and a dopant is required so that holes and electrons each migrate to the dopant through stable electrochemical paths to form excitons.

### [Detailed Description of the Invention]

### [Problems to be Solved by the Invention]

Accordingly, the present invention is directed to providing a light-emitting layer host material having a characteristic structure, and a high-efficiency and long-lifespan organic light-emitting device having low-voltage driving, and significantly improved light-emitting efficiency and lifespan by including the host material.

### [Means for Solving the Problems]

In order to resolve the above-described problems, one aspect of the present invention provides an organic light-emitting device including: a first electrode; a second electrode provided opposite to the first electrode; and an organic layer interposed between the first electrode and the second electrode, wherein the organic layer includes a light-emitting layer including a host and a dopant, the host includes a first compound and a second compound, and the first compound includes at least one organic compound represented by the following [Chemical Formula 1].

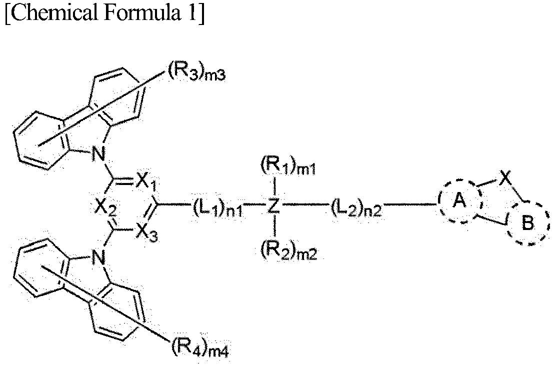

Specific structures of [Chemical Formula 1], specific compounds according to the present invention obtained therefrom, and a definition of each substituent will be described later.

### [Effects of the Invention]

An organic light-emitting device according to the present invention includes a plurality of host compounds in a light-emitting layer and employs a compound having a characteristic structure as one host material, thereby achieving properties of high efficiency and long lifespan having low-voltage driving, and significantly improved light-emitting efficiency and lifespan. Accordingly, the organic light-emitting device can be effectively utilized not only in lighting devices, but also in various display devices such as flat-panel, flexible and wearable displays, displays for vehicles or aviation, and displays for virtual or augmented reality.

### [Best Mode for Carrying out the Invention]

Hereinafter, the present invention will be described in more detail.

One aspect of the present invention relates to an organic light-emitting device including: a first electrode; a second electrode provided opposite to the first electrode; and an organic layer interposed between the first electrode and the second electrode, wherein the organic layer includes a light-emitting layer including a host and a dopant, the host includes a first compound and a second compound, and the first compound includes at least one organic compound represented by the following [Chemical Formula 1].

Herein, the first compound represented by [Chemical Formula 1] is an organic compound having a structure in which a benzene derivative skeleton including nitrogen is substituted with two carbazole groups and a silyl group substituted with a characteristic substituent. Due to such characteristics, a high-efficiency and long-lifespan organic light-emitting device having low-voltage driving, and significantly improved light-emitting efficiency and lifespan may be achieved by including a plurality of host compounds in a light-emitting layer and employing the compound of the following [Chemical Formula 1] having a characteristic structure as one host material.

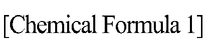

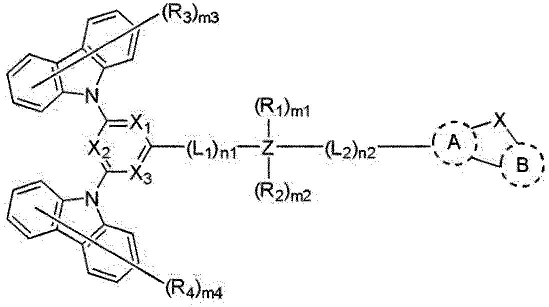

In [Chemical Formula 1],
X₁ to X₃ are the same as or different from each other and each independently N or CR, at least one of X₁ to X₃ is N, and according to one embodiment of the present invention, X₁ to X₃ may all be N.
Z is Si or Ge.
X is any one selected from O, S, NR₅, CR₆R₇, SiR₈R₉ and GeR₁₀R₁₁, and according to one embodiment of the present invention, X may be O or S.
R₁ and R₂ are the same as or different from each other, and each independently any one selected from a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, and a substituted or unsubstituted fused cyclic group of C₃-C₃₀ aliphatic ring and C₅-C₃₀ aromatic ring.

According to one embodiment of the present invention, R₁ and R₂ are the same as or different from each other, and may be each independently any one selected from a substituted or unsubstituted C₆-C₂₀ aryl group, a substituted or unsubstituted C₅-C₂₀ heteroaryl group, and a substituted or unsubstituted fused cyclic group of C₃-C₁₈ aliphatic ring and C₅-C₁₈ aromatic ring.

m₁ and m₂ are each independently an integer of 1 to 3, and when each of m₁ and m₂ is an integer of 2 or greater, the respective R₁s and R₂s are the same as or different from each other.

R and R₃ to R₁₁ are the same as or different from each other, and each independently any one selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted fused cyclic group of C₃-C₃₀ aliphatic ring and C₅-C₃₀ aromatic ring, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group.

m₃ and m₄ are each independently an integer of 8, the respective R₃s and R₄s are the same as or different from each other, and according to one embodiment of the present invention, R₃ and R₄ may all be deuterium atoms.

The plurality of adjacent R₃s and R₄s may be linked to each other to further form an alicyclic or aromatic monocyclic or polycyclic ring.

In addition, R₆ and R₇, R₈ and R₉, and R₁₀ and R₁₁ may be linked to each other to further form an alicyclic or aromatic monocyclic or polycyclic ring.

L₁ and L₂ are the same as or different from each other, and each independently any one selected from a substituted or unsubstituted C₆-C₃₀ arylene group, a substituted or unsubstituted C₂-C₃₀ heteroarylene group, and a substituted or unsubstituted fused divalent cyclic group of C₃-C₂₄ aliphatic ring and C₅-C₂₄ aromatic ring.

According to one embodiment of the present invention, L₁ and L₂ are the same as or different from each other, and may be each independently a substituted or unsubstituted C₆-C₂₀ arylene group.

n₁ and n₂ are each independently an integer of 1 to 3, and when each of n₁ and n₂ is an integer of 2 or greater, the respective L₁s and L₂s are the same as or different from each other.

A and B are the same as or different from each other, and each independently any one selected from a substituted or unsubstituted C₆-C₃₀ aromatic hydrocarbon ring, a substituted or unsubstituted C₃-C₃₀ aliphatic hydrocarbon ring, a substituted or unsubstituted C₂-C₃₀ aromatic heteroring, a substituted or unsubstituted C₂-C₃₀ aliphatic heteroring, and a substituted or unsubstituted fused ring of C₃-C₂₄ aliphatic ring and C₅-C₂₄ aromatic ring.

According to one embodiment of the present invention, B may be a substituted or unsubstituted C₆-C₂₀ aromatic hydrocarbon ring.

In addition, the 'substituted' in the 'substituted or unsubstituted' in [Chemical Formula 1] means being substituted with one or more substituents selected from the group consisting of deuterium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a fused cyclic group of C₃-C₂₄ aliphatic ring and C₅-C₂₄ aromatic ring, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, and when there are two or more substituents, they are the same as or different from each other, and at least one hydrogen in each of the substituents may be substituted with deuterium.

In addition, the organic compound represented by [Chemical Formula 1] according to the present invention is characterized in that at least one hydrogen in [Chemical Formula 1] is substituted with deuterium.

In addition, according to one embodiment of the present invention, the organic compound represented by [Chemical Formula 1] may be represented by the following [Chemical Formula 1-1].

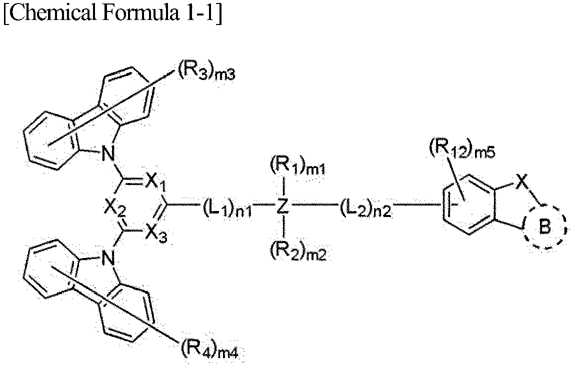

In [Chemical Formula 1-1],
R₁₂s are the same as or different from each other, and each independently any one selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₃₀ heteroaryl group, a substituted or unsubstituted fused cyclic group of C₃-C₃₀ aliphatic ring and C₅-C₃₀ aromatic ring, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group, and
m₅ is an integer of 3, and the respective R₁₂s are the same as or different from each other.

The plurality of adjacent R₁₂s may be linked to each other to further form an alicyclic or aromatic monocyclic or polycyclic ring.

X, X₁ to X₃, Z, R₁ to R₄, L₁, L₂, n₁, n₂, m₁ to m₄, and ring B have the same definitions as in [Chemical Formula 1].

In addition, the light-emitting layer has a structure formed with a host and a dopant, and the light-emitting layer may further include a dopant material. Herein, the content of the dopant may be commonly selected in a range of about 0.01 parts by weight to about 20 parts by weight based on about 100 parts by weight of the host, however, the content is not limited thereto.

In the present invention, as the dopant compound included in the light-emitting layer, the dopant includes, instead of a fluorescent dopant material transferred only to a singlet state using a Forster energy transfer method in an existing host-dopant system, a phosphorescent dopant material of a metal complex including at least one metal selected from Ir, Pt, Os, Ti, Zr, Hf, Eu, Tb, Tm, Fe, Co, Ni, Ru, Rh, Re, Pd and the like using a Dexter energy transfer method transferred without distinguishing single and triplet states. Known dopant materials may be used without particular limit as long as they emit light from triplet excitons.

As the metal complex, Ir, Pt, Pd and the like may be preferably selected, and specific examples thereof may include Ir(ppy)₃, Ir(ppy)₂acac, Ir(Bt)₂acac, Ir(MDQ)₂acac, Ir(mppy)₃, Ir(piq)₃, Ir(piq)₂acac, Ir(pq)₂acac, Ir(mpp)₂acac, F₂Irpic, (F₂ppy)₂Ir(tmd), Ir(ppy)₂tmd, Ir(pmi)₃, Ir(pmb)₃, FCNIr, FCNIrpic, FIr₆, FIrN₄, FIrpic, PtOEP, Ir(chpy)₃,P0-01(C₃₁H₂₃IrN₂O₂S₂), Ir(ppz)₃, Ir(dfppz)₃, PtNON, Pt-10, Pt-11 and the like. However, the metal complex is not limited thereto.

In addition, the light-emitting layer may further include various host and dopant materials in addition to the host and the dopant compounds according to the present invention, and accordingly, the dopant material as well as the host material may be used in the light-emitting layer by mixing or laminating one or more compounds that are different from each other.

Herein, when two or more host compounds are mixed or laminated and used by further including at least one additional host compound in addition to the compound represented by [Chemical Formula 1], a compound having an electron donor moiety may be used as the additional host, and by the HOMO/LUMO level of high hole injection and electron injection barrier resulting from mixing or laminating with [Chemical Formula 1] having an azine moiety, a nitrogen-containing aromatic heteroring that is an electron acceptor moiety, the recombination region is limited to the interface between the two hosts, and as a result, a high-efficiency and long-lifespan organic light-emitting device may be achieved due to advantages of minimizing a current loss, and the like.

Herein, the compound having an electron donor moiety is a compound having a moiety with an environment that readily donates electrons from the outside in the molecule, such as a compound having an amine group and a compound substituted with carbazole, and may preferably include a compound including an aromatic hydrocarbon ring including a tertiary amine in the molecule; or an aromatic hydrocarbon ring including carbazole and bicarbazole in the molecule.

In addition, according to one embodiment of the present invention, the plurality of hosts in the light-emitting layer of the organic light-emitting device according to the present invention may be used by mixing at least one organic compound represented by the following [Chemical Formula 3] in addition to the compound represented by [Chemical Formula 1], or by laminating a compound represented by the following [Chemical Formula 3] on an upper or lower portion of a layer including the compound represented by [Chemical Formula 1].

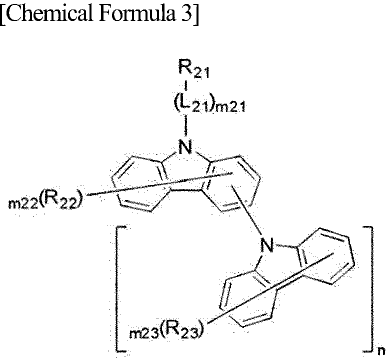

In [Chemical Formula 3],
L₂₁s are each independently a single bond, or any one selected from a substituted or unsubstituted C₆-C₃₀ arylene group, a substituted or unsubstituted C₂-C₃₀ heteroarylene group, and a substituted or unsubstituted fused divalent cyclic group of C₃-C₂₄ aliphatic ring and C₅-C₂₄ aromatic ring.
R₂₁ to R₂₃ are the same as or different from each other, and each independently any one selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted fused cyclic group of C₃-C₃₀ aliphatic ring and C₅-C₃₀ aromatic ring, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group.
m₂₁ is an integer of 1 or 2, and when m₂₁ is an integer of 2, the respective L₂₁s are the same as or different from each other.
m₂₂ is an integer of 7 or 8, and the respective R₂₂s are the same as or different from each other.
m₂₃ is an integer of 8, and the respective R₂₃s are the same as or different from each other.
n is an integer of 0 or 1.

The 'substituted' in the 'substituted or unsubstituted' in [Chemical Formula 3] means being substituted with one or more substituents selected from the group consisting of deuterium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a fused cyclic group of C₃-C₂₄ aliphatic ring and C₃-C₂₄ aromatic ring, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, and when there are two or more substituents, they are the same as or different from each other, and at least one hydrogen in each of the substituents may be substituted with deuterium.

In addition, the organic compound represented by [Chemical Formula 1] used in the host is used in a blue phosphorescent host.

In addition, the organic layer of the organic light-emitting device according to the present invention may be formed in a single layer structure, but may be formed in a multilayer structure in which two or more organic layers are laminated. For example, the organic layer may have a structure including a hole injecting layer, a hole transport layer, a hole blocking layer, a light-emitting layer, an electron blocking layer, an electron transport layer, an electron injecting layer and the like. However, the structure is not limited thereto, and may also include a smaller or larger number of organic layers, and a preferred organic material layer structure of the organic light-emitting device according to the present invention will be described in more detail in examples to be described later.

In addition, according to one embodiment of the present invention, the dopant may include at least one organometallic compound, and the dopant may be used by mixing or laminating a polycyclic compound represented by the following [Chemical Formula 2] in addition to the organometallic compound.

Accordingly, in the organic light-emitting device according to one embodiment of the present invention, the light-emitting layer may be formed to include a first compound, a second compound, an organometallic compound and a polycyclic compound (boron thermally activated delayed fluorescent light-emitting body) of the following [Chemical Formula 2].

In this case, the organometallic compound may function as a sensitizer, and the polycyclic compound may function as a light-emitting dopant, so that the sensitizer compound may receive excitons from the first compound and the second compound, and transfer the excitons to the light-emitting dopant.

Accordingly, excitons are transferred from the sensitizer to the light-emitting dopant compound via Dexter energy transfer (DET) or Forster resonance energy transfer (FRET) mechanism, and the exciton energy transferred to the light-emitting dopant compound may emit light while transitioning to a ground state. Herein, the excitons of the sensitizer may be transferred from the first compound and the second compound via FRET mechanism, or may be formed by transferring excitons generated from the host vis DET mechanism.

Accordingly, energy is readily transferred between the sensitizer and the light-emitting dopant via FRET and DET mechanisms, and triplet-triplet annihilation is suppressed, enabling manufacture of a high-efficiency organic light-emitting device.

The boron thermally activated delayed fluorescent light-emitting body that is the polycyclic compound represented by the following [Chemical Formula 2] may improve the lifespan by allowing Forster energy transfer from the triplet of the phosphorescence sensitizer to the singlet of the boron thermally activated delayed fluorescent light-emitting body, thereby reducing the number of long-lived triplet excitons involved in device degradation. In addition, its high molar absorption coefficient increases the rate of fluorescence resonance energy transfer from the phosphorescence sensitizer to the light emitting body, and its multiple resonance effect narrows the emission spectrum, resulting in increased color purity, and as a result, efficiency and lifespan are improved by these effects.

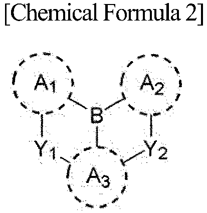

In [Chemical Formula 2],
Y₁ and Y₂ are the same as or different from each other, and each independently any one selected from O, S, NR₁₃, CR₁₄R₁₅, SiR₁₆R₁₇ and GeR₁₈R₁₉.
A₁ to A₃ are the same as or different from each other, and each independently any one selected from a substituted or unsubstituted C₆-C₃₀ aromatic hydrocarbon ring, a substituted or unsubstituted C₃-C₃₀ aliphatic hydrocarbon ring, a substituted or unsubstituted C₂-C₃₀ aromatic heteroring, a substituted or unsubstituted C₂-C₃₀ aliphatic heteroring, and a substituted or unsubstituted fused ring of C₃-C₂₄ aliphatic ring and C₃-C₂₄ aromatic ring.
R₁₃ to R₁₉ are the same as or different from each other, and each independently any one selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₃₀ aryl group, a substituted or unsubstituted C₃-C₅₀ cycloalkyl group, a substituted or unsubstituted C₂-C₃₀ heterocycloalkyl group, a substituted or unsubstituted C₂-C₃₀ heteroaryl group, a substituted or unsubstituted fused cyclic group of C₃-C₃₀ aliphatic ring and C₃-C₃₀ aromatic ring, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group.
R₁₃ to R₁₉ may be linked to the rings A₁ to A₃ to further form an alicyclic or aromatic monocyclic or polycyclic ring.
R₁₄ and R₁₅, R₁₆ and R₁₇, and R₁₈ and R₁₉ may each be linked to each other to further form an alicyclic or aromatic monocyclic or polycyclic ring.

In addition, the 'substituted' in the 'substituted or unsubstituted' in [Chemical Formula 2] means being substituted with one or more substituents selected from the group consisting of deuterium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a fused cyclic group of C₃-C₂₄ aliphatic ring and C₃-C₂₄ aromatic ring, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, and when there are two or more substituents, they are the same as or different from each other, and at least one hydrogen in each of the substituents may be substituted with deuterium.

Meanwhile, in the present invention, the range of the number of carbon atoms in the alkyl group or aryl group in the 'substituted or unsubstituted C₁-C₃₀ alkyl group', 'substituted or unsubstituted C₆-C₅₀ aryl group' and the like refers to the total number of carbon atoms forming the alkyl or aryl moiety when unsubstituted without considering the moiety substituted with the substituents. For example, it means that a phenyl group substituted with a butyl group at a para position corresponds to a C₆ aryl group substituted with a C₄ butyl group.

In addition, in the present invention, being linked to each other or to adjacent groups to further form a ring may mean that adjacent substituents among the specified substituents may bond to each other or the specified substituent and another adjacent group may bond to each other to form a substituted or unsubstituted alicyclic or aromatic ring, and the 'adjacent group' may refer to a substituent substituting on an atom directly linked to an atom substituted with the corresponding substituent, a substituent positioned sterically closest to the corresponding substituent, or another substituent substituting on an atom substituted with the corresponding substituent. For example, two substituents substituting at an ortho position of a benzene ring and two substituents substituting on the same carbon in an aliphatic ring may be interpreted as 'adjacent groups' to each other, and the linked pair of substituents each lose one hydrogen radical and linked to each other to further form a ring, and the carbon atoms of the formed alicyclic or aromatic monocyclic or polycyclic ring may be replaced by heteroatoms such as N, O, S, Si and Ge.

In the present invention, the alkyl group may be linear or branched. Specific examples thereof may include a methyl group, an ethyl group, a propyl group, an n-propyl group, an isopropyl group, a butyl group, an n-butyl group, an isobutyl group, a tert-butyl group, a sec-butyl group, a 1-methyl-butyl group, a 1-ethyl-butyl group, a pentyl group, an n-pentyl group, an isopentyl group, a neopentyl group, a tert-pentyl group, a hexyl group, an n-hexyl group, a 1-methylpentyl group, a 2-methylpentyl group, a 4-methyl-2-pentyl group, a 3,3-dimethylbutyl group, a 2-ethylbutyl group, a heptyl group, an n-heptyl group, a 1-methylhexyl group, a cyclopentylmethyl group, a cyclohexylmethyl group, an octyl group, an n-octyl group, a tert-octyl group, a 1-methylheptyl group, a 2-ethylhexyl group, a 2-propylpentyl group, an n-nonyl group, a 2,2-dimethylheptyl group, a 1-ethyl-propyl group, a 1,1-dimethyl-propyl group, an isohexyl group, a 2-methylpentyl group, a 4-methylhexyl group, a 5-methylhexyl group and the like, but are not limited thereto.

In the present invention, specific examples of the arylalkyl group may include phenylmethyl (benzyl), phenylethyl, phenylpropyl, naphthylmethyl, naphthylethyl and the like, but are not limited thereto.

In the present invention, specific examples of the alkylaryl group may include tolyl, xylenyl, dimethylnaphthyl, t-butylphenyl, t-butylnaphthyl, t-butylphenanthryl and the like, but are not limited thereto.

In the present invention, the alkenyl group includes linear or branched forms, and may be further substituted with other substituents. Specific examples thereof may include a vinyl group, a 1-propenyl group, an isopropenyl group, a 1-butenyl group, a 2-butenyl group, a 3-butenyl group, a 1-pentenyl group, a 2-pentenyl group, a 3-pentenyl group, a 3-methyl-1-butenyl group, a 1,3-butadienyl group, an allyl group, a 1-phenylvinyl-1-yl group, a 2-phenylvinyl-1-yl group, a 2,2-diphenylvinyl-1-yl group, a 2-phenyl-2-(naphthyl-1-yl)vinyl-1-yl group, a 2,2-bis(diphenyl-1-yl)vinyl-1-yl group, a stilbenyl group, a styrenyl group and the like, but are not limited thereto.

In the present invention, the alkynyl group also includes linear or branched forms, and may be further substituted with other substituents. Examples thereof may include ethynyl, 2-propynyl and the like, but are not limited thereto.

In the present invention, the cycloalkenyl group is a non-aromatic cyclic unsaturated hydrocarbon group having one or more carbon double bonds. Examples thereof may include cyclopropenyl, cyclobutenyl, cyclopentenyl, cyclohexenyl, cycloheptenyl, 1,3-cyclohexadienyl, 1,4-cyclohexadienyl, 2,4-cycloheptadienyl, 1,5-cyclooctadienyl and the like, but are not limited thereto.

In the present invention, the aromatic hydrocarbon ring or the aryl group may be monocyclic or polycyclic. The term 'polycyclic group' refers to a group directly linked to or fused with other cyclic groups, and the other cyclic group may be an aromatic hydrocarbon ring, but may also be other types of cyclic groups such as an aliphatic heteroring, an aliphatic hydrocarbon ring and an aromatic heteroring. Examples of the monocyclic aryl group may include a phenyl group, a biphenyl group, a terphenyl group and the like, and examples of the polycyclic aryl group may include a naphthyl group, an anthracenyl group, a phenanthrenyl group, a pyrenyl group, a perylenyl group, a tetracenyl group, a chrysenyl group, a fluorenyl group, an acenaphathcenyl group, a triphenylene group, a fluoranthrene group and the like, however, the scope of the present invention is not limited to these examples.

In the present invention, the aromatic heteroring or the heteroaryl group is an aromatic ring including one or more of heteroatoms such as O, S, N, P, Si or Ge. Examples thereof may include a thiophene group, a furan group, a pyrrole group, an imidazole group, a thiazole group, an oxazole group, an oxadiazole group, a triazole group, a pyridyl group, a bipyridyl group, a pyrimidyl group, a triazine group, a triazole group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, an indolocarbazole group, a benzoxazole group, a benzimidazole group, a benzothiazole group, a benzocarbazole group, a benzothiophene group, a dibenzothiophene group, a benzofuranyl group, a dibenzofuranyl group, a phenanthroline group, a thiazolyl group, an isoxazolyl group, an oxadiazolyl group, a thiadiazolyl group, a benzothiazolyl group, a phenothiazinyl and the like, but are not limited thereto.

In the present invention, the aliphatic hydrocarbon ring or the cycloalkyl group refers to a non-aromatic ring formed only with carbon and hydrogen atoms. Examples thereof may include monocyclic or polycyclic groups, and the aliphatic hydrocarbon ring or the cycloalkyl group may be further substituted with other substituents. The term 'polycyclic group' refers to a group directly linked to or fused with other cyclic groups, and the other cyclic group may be an aliphatic hydrocarbon ring, but may also be other types of cyclic groups such as an aliphatic heteroring, an aromatic hydrocarbon ring and an aromatic heteroring. Specific examples thereof may include a cycloalkyl group such as a cyclopropyl group, a cyclobutyl group, a cyclopentyl group, an adamantyl group, a bicycloheptanyl group, a 3-methylcyclopentyl group, a 2,3-dimethylcyclopentyl group, a cyclohexyl group, a 3-methylcyclohexyl group, a 4-methylcyclohexyl group, a 2,3-dimethylcyclohexyl group, a 3,4,5-trimethylcyclohexyl group, a 4-tert-butylcyclohexyl group, a cycloheptyl group and a cyclooctyl group, a cycloalkane group such as a cyclohexane group and a cyclopentane group, and a cycloalkene group such as a cyclohexene group and a cyclobutene group, but are not limited thereto.

In the present invention, the aliphatic heteroring or the heterocycloalkyl group refers to an aliphatic ring including one or more of heteroatoms such as O, S, Se, N, Si or Ge, includes monocyclic or polycyclic groups as well, and may be further substituted with other substituents. The term 'polycyclic group' refers to a group in which heterocycloalkyl, heterocycloalkane or the like is directly linked to or fused with other cyclic groups, and the other cyclic group may be an aliphatic heteroring, but may also be other types of cyclic groups such as an aliphatic hydrocarbon ring, an aromatic hydrocarbon ring and an aromatic heteroring.

In the present invention, the fused ring (cyclic group) of aliphatic ring and aromatic ring is an aliphatic-aromatic mixed ring (cyclic group), and refers to a ring in which two or more rings are linked to and fused with each other, and an aliphatic ring and an aromatic ring are fused to have non-aromaticity overall. More specifically, the fused ring (cyclic group) of aliphatic ring and aromatic ring may include an aromatic hydrocarbon ring (cyclic group) fused with an aliphatic hydrocarbon ring, an aromatic hydrocarbon ring (cyclic group) fused with an aliphatic heteroring, an aromatic heteroring (cyclic group) fused with an aliphatic hydrocarbon ring, an aromatic heteroring (cyclic group) fused with an aliphatic heteroring, an aliphatic hydrocarbon ring (cyclic group) fused with an aromatic hydrocarbon ring, an aliphatic hydrocarbon ring (cyclic group) fused with an aromatic heteroring, an aliphatic heteroring (cyclic group) fused with an aromatic hydrocarbon ring, an aliphatic heteroring (cyclic group) fused with an aromatic heteroring, and the like, and specific examples thereof may include a tetrahydronaphthyl group, a tetrahydrobenzocycloheptene group, a tetrahydrophenanthrene group, a tetrahydroanthracenyl group, an octahydrotriphenylene group, a tetrahydrobenzothiophene group, a tetrahydrobenzofuranyl group, a tetrahydrocarbazole group, a tetrahydroquinoline group and the like. In addition, a heteroatoms such as O, S, N, P, Si or Ge may replace other than carbon in the fused ring (cyclic group) of aliphatic ring and aromatic ring.

In the present invention, the alkoxy group may specifically be methoxy, ethoxy, propoxy, isobutyloxy, sec-butyloxy, pentyloxy, iso-amyloxy, hexyloxy or the like, but is not limited thereto.

In the present invention, the silyl group may include -SiH₃, an alkylsilyl group, an arylsilyl group, an alkylarylsilyl group, an arylheteroarylsilyl group, a heteroarylsilyl group and the like. The arylsilyl group refers to a silyl group in which one, two or three hydrogen atoms are substituted with an aryl group in -SiH₃, the alkylsilyl group refers to a silyl group in which one, two or three hydrogen atoms are substituted with an alkyl group in -SiH₃, the alkylarylsilyl group refers to a silyl group including one or two alkyl groups and two or one aryl groups corresponding thereto by at least one hydrogen atom being substituted with an alkyl group and an aryl group in -SiH₃, the arylheteroarylsilyl group refers to a silyl group including one or two aryl groups and two or one heteroaryl groups corresponding thereto by at least one hydrogen atom being substituted with an aryl group and a heteroaryl group in -SiH₃, and the heteroarylsilyl group refers to a silyl group in which one, two or three hydrogen atoms are substituted with a heteroaryl group in -SiH₃. Examples of the arylsilyl group may include a substituted or unsubstituted monoarylsilyl group, a substituted or unsubstituted diarylsilyl group or a substituted or unsubstituted triarylsilyl group, and the same also applies to the alkylsilyl group and the heteroarylsilyl group.

Herein, the aryl group in each of the arylsilyl group, the heteroarylsilyl group and the arylheteroarylsilyl group may be a monocyclic aryl group or a polycyclic aryl group, and the heteroaryl group in each of the arylsilyl group, the heteroarylsilyl group and the arylheteroarylsilyl group may be a monocyclic heteroaryl group or a polycyclic heteroaryl group.

In addition, specific examples of the silyl group may include trimethylsilyl, triethylsilyl, triphenylsilyl, trimethoxysilyl, dimethoxyphenylsilyl, diphenylmethylsilyl, diphenylvinylsilyl, methylcyclobutylsilyl, dimethylfurylsilyl and the like, and one or more hydrogen atoms in the silyl group may be substituted with the same substituents as in the case of the aryl group.

In the present invention, the amine group may include -NH₂, an alkylamine group, an arylamine group, an alkylarylamine group, an arylheteroarylamine group, a heteroarylamine group and the like. The arylamine group refers to an amine group in which one or two hydrogen atoms are substituted with an aryl group in -NH₂, the alkylamine group refers to an amine group in which one or two hydrogen atoms are substituted with an alkyl group in -NH₂, and the alkylarylamine group refers to an amine group in which one hydrogen atom is substituted with an alkyl group and the other hydrogen atom is substituted with an aryl group in -NH₂. The arylheteroarylamine group refers to an amine group in which one hydrogen atom is substituted with an aryl group and the other hydrogen atom is substituted with a heteroaryl group in -NH₂, and the heteroarylamine group refers to an amine group in which one or two hydrogen atoms are substituted with a heteroaryl group in -NH₂. Examples of the arylamine group may include a substituted or unsubstituted monoarylamine group, a substituted or unsubstituted diarylamine group or a substituted or unsubstituted triarylamine griyo, and the same also applies to the alkylamine group and the heteroarylamine group.

Herein, the aryl group in each of the arylamine group, the heteroarylamine group and the arylheteroarylamine group may be a monocyclic aryl group or a polycyclic aryl group, and the heteroaryl group in each of the arylamine group, the heteroarylamine group and the arylheteroarylamine group may be a monocyclic heteroaryl group or a polycyclic heteroaryl group.

In the present invention, the germanium group (or germane group) may include - GeH₃, an alkylgermanium group, an arylgermanium group, a heteroarylgermanium group, an alkylarylgermanium group, an alkylheteroarylgermanium group, an arylheteroarylgermanium group and the like. Definitions thereof follow the description provided for the silyl group, and may be applied to each substituent as a substituent obtained by being substituted with a germanium (Ge) atom instead of a silicon (Si) atom in the silyl group.

In addition, specific examples of the germanium group may include trimethylgermane, triethylgermane, triphenylgermane, trimethoxygermane, dimethoxyphenylgermane, diphenylmethylgermane, diphenylvinylgermane, methylcyclobutylgermane, dimethylfurylgermane and the like, and one or more hydrogen atoms in the germanium group may be substituted with the same substituents as in the case of the aryl group.

The cycloalkyl group, the aryl group and the heteroaryl group in the cycloalkyloxy group, the aryloxy group, the heteroaryloxy group, the cycloalkylthioxy group, the arylthioxy group and the heteroarylthioxy group are the same as the examples of the cycloalkyl group, the aryl group and the heteroaryl group provided above. Specific examples of the aryloxy group may include a phenoxy group, a p-tolyloxy group, an m-tolyloxy group, a 3,5-dimethylphenoxy group, a 2,4,6-trimethylphenoxy group, a p-tert-butylphenoxy group, a 3-biphenyloxy group, a 4-biphenyloxy group, a 1-naphthyloxy group, a 2-naphthyloxy group, a 4-methyl-1-naphthyloxy group, a 5-methyl-2-naphthyloxy group, a 1-anthryloxy group, a 2-anthryloxy group, a 9-anthryloxy group, a 1-phenanthryloxy group, a 3-phenanthryloxy group, a 9-phenanthryloxy group and the like, and specific examples of the arylthioxy group may include a phenylthioxy group, a 2-methylphenylthioxy group, a 4-tert-butylphenylthioxy group and the like. However, the aryloxy group and the arylthioxy group are not limited thereto.

In the present invention, examples of the halogen group include fluorine, chlorine, bromine or iodine.

According to one embodiment of the present invention, the compound represented by [Chemical Formula 1] may be any one selected from compounds represented by the following chemical formulae, however, the scope of the present invention is not limited thereby.

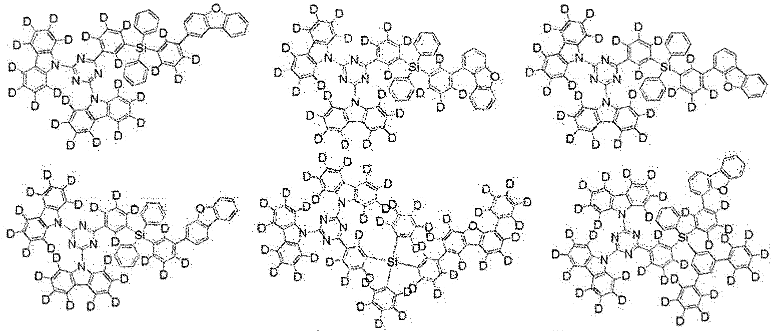

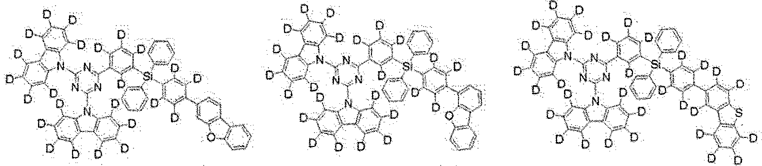

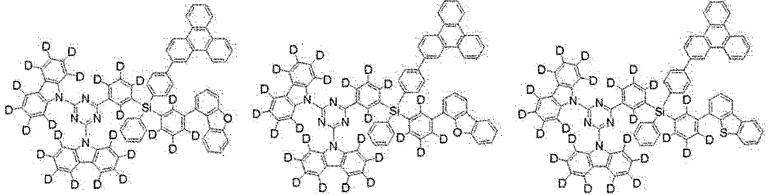

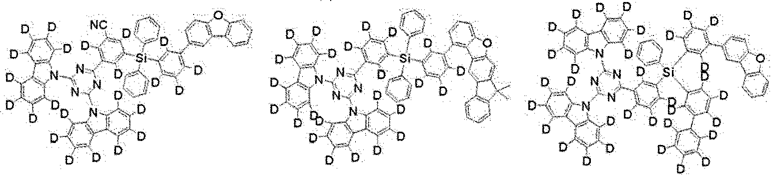

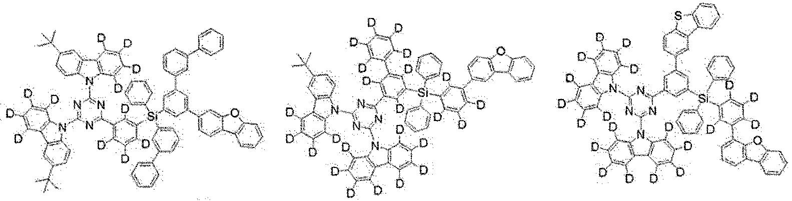

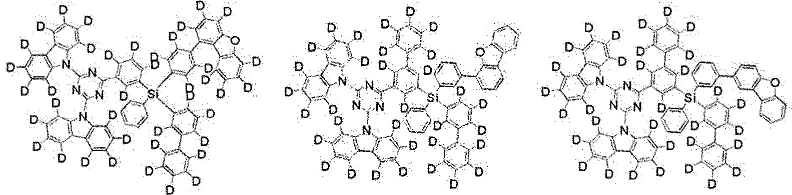

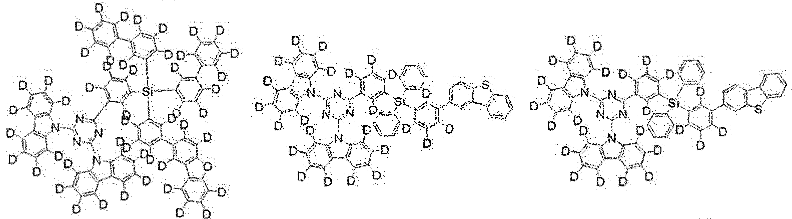

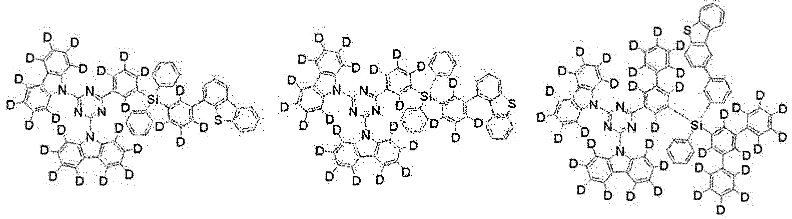

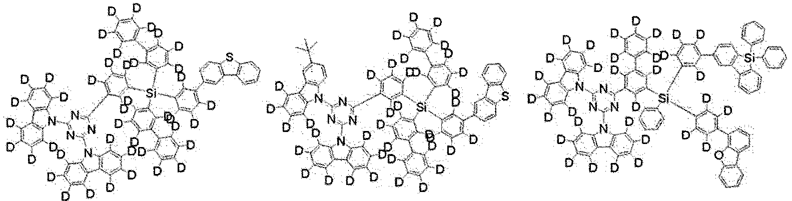

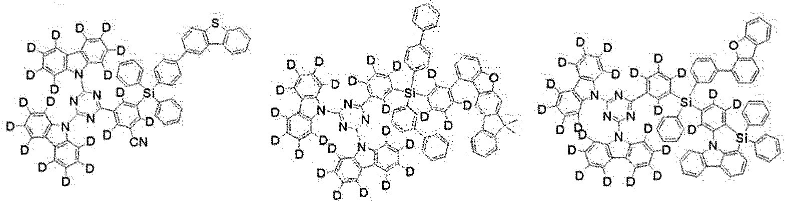

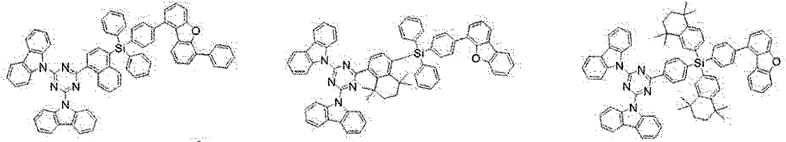

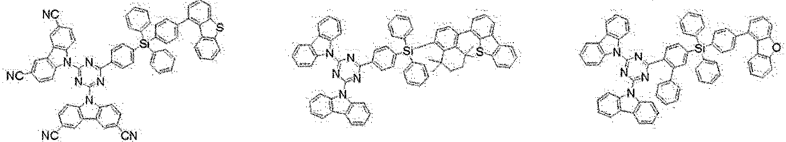

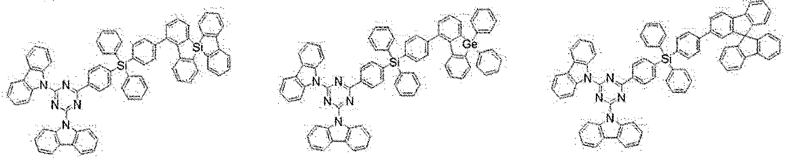

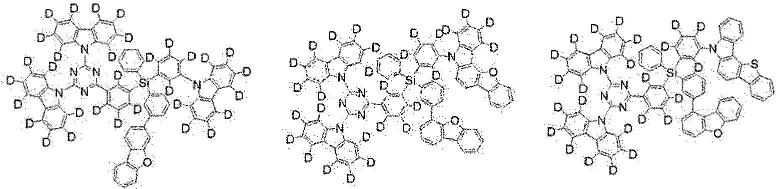

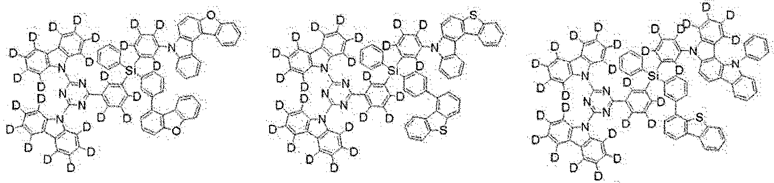

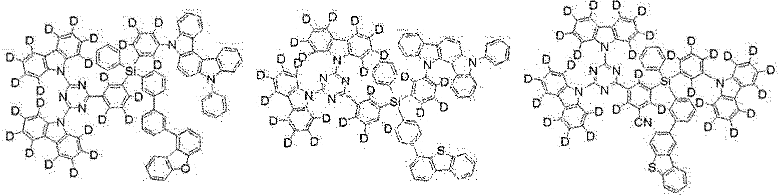

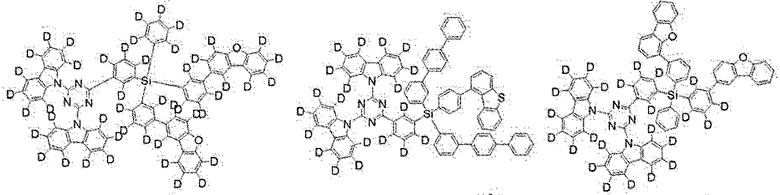

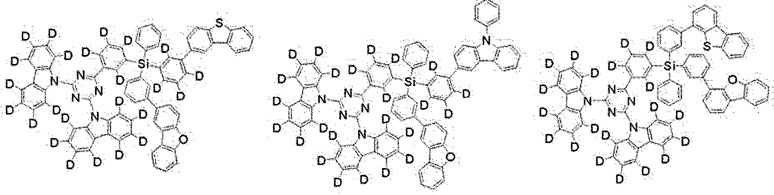

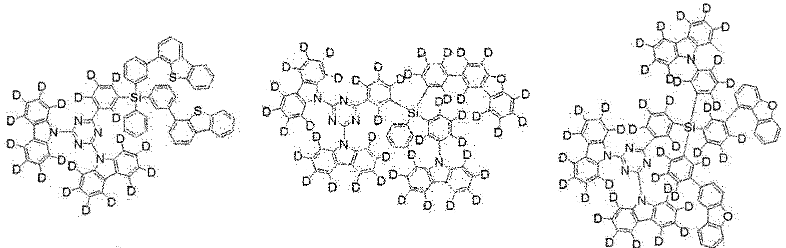

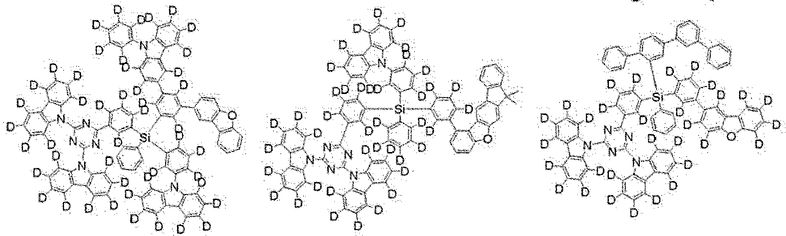

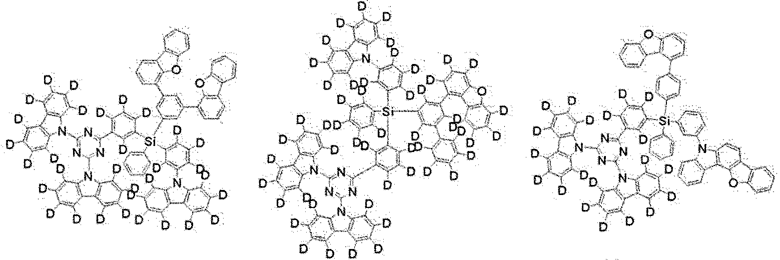

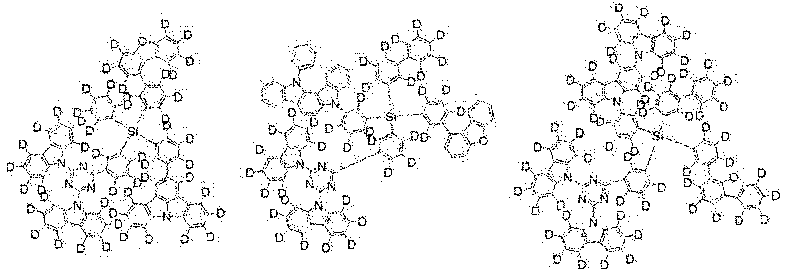

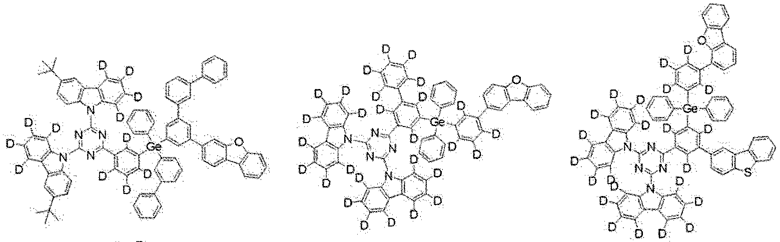

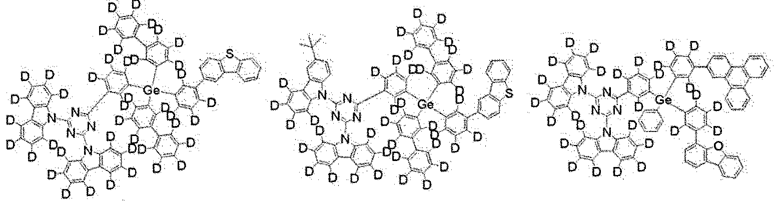

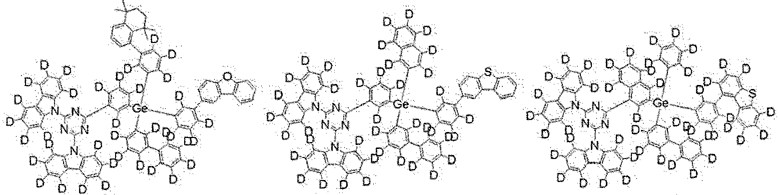

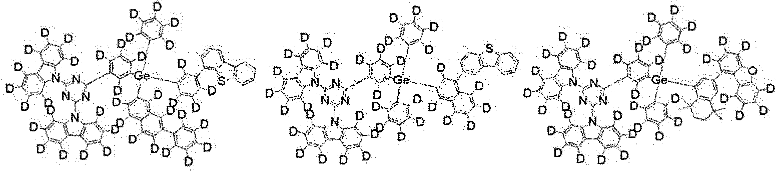

Hereinafter, one embodiment of the organic light-emitting device according to the present invention will be described in more detail.

The organic light-emitting device of the present invention includes an anode, a hole transport layer, a light-emitting layer, an electron transport layer and a cathode. As necessary, the organic light-emitting device of the present invention may further include a hole injecting layer between the anode and the hole transport layer, and an electron injecting layer between the electron transport layer and the cathode. In addition thereto, one or two intermediate layers may be further formed, a hole blocking layer or an electron blocking layer may be further formed, and as described above, organic layers having various functions such as a capping layer may be further included depending on the device properties.

Meanwhile, the specific structure of the organic light-emitting device according to one embodiment of the present invention, a method for manufacturing the same, and the materials of each organic layer may be examined as follows.

First, a material for an anode electrode is coated on a substrate to form an anode. Herein, substrates used in common organic light-emitting devices may be used as the substrate, and organic substrates or transparent plastic substrates having excellent transparency, surface smoothness, handling readiness and waterproofness are preferred. As the material for an anode electrode, indium tin oxide (ITO), indium zinc oxide (IZO), tin oxide (SnO₂), zinc oxide (ZnO) or the like, which is transparent and has excellent conductivity, is used.

A hole injecting layer material is coated on the anode electrode by vacuum thermal deposition or spin coating to form a hole injecting layer. Then, a hole transport layer material is coated on the hole injecting layer by vacuum thermal deposition or spin coating to form a hole transport layer.

The hole injecting layer material is not particularly limited as long as it is commonly used in the art. Examples thereof may include 4,4',4"-tris(2-naphthylphenyl-phenylamino)triphenylamine (2-TNATA), N,N'-di(1-naphthyl)-N,N'-diphenylbenzidine (NPD), N,N'-diphenyl-N,N'-bis(3-methylphenyl)-1,1'-biphenyl-4,4'-diamine (TPD), N,N'-diphenyl-N,N'-bis(4-(phenyl-m-tolylamino)phenyl)biphenyl-4,4'-diamine (DNTPD), 1,4,5,8,9,11-hexaazatriphenylenehexacarbonitrile (HAT-CN), and the like.

The hole transport layer material is not particularly limited as well as long as it is commonly used in the art. Examples thereof may include N,N'-bis(3-methylphenyl)-N,N'-diphenyl-(1,1-biphenyl)-4,4'-diamine (TPD), N,N'-di(naphthalen-1-yl)-N,N'-diphenylbenzidine (α-NPD) and the like.

Subsequently, a hole auxiliary layer and a light-emitting layer are sequentially laminated on the hole transport layer, and a hole blocking layer may be optionally formed as a thin film on the light-emitting layer using a method of vacuum deposition or spin coating. When holes pass through an organic light-emitting layer and flow into a cathode, lifespan and efficiency of a device are reduced, and the hole blocking layer performs a role of preventing this problem by using a material having a very low highest occupied molecular orbital (HOMO) level. The hole blocking material used herein is not particularly limited, but needs to have higher ionization potential than a light-emitting compound while having an electron transport ability. Representative examples thereof may include BAlq, BCP, TPBI and the like.

As a material used for the hole blocking layer, BAlq, BCP, Bphen, TPBI, TAZ, BeBq₂, OXD-7, Liq and the like may be used, however, the material is not limited thereto.

After depositing an electron transport layer on the hole blocking layer using a method of vacuum deposition or spin coating, an electron injecting layer is formed thereon, and a metal for forming a cathode is vacuum thermal deposited on the electron injecting layer to form a cathode, and as a result, the organic light-emitting device according to one embodiment of the present invention is completed.

Herein, as the metal for forming a cathode, lithium (Li), magnesium (Mg), aluminum (Al), aluminum-lithium (Al-Li), calcium (Ca), magnesium-indium (Mg-In), magnesium-silver (Mg-Ag) or the like may be used, and in order to obtain a top emission-type light-emitting device, a transmissive cathode using ITO or IZO may be used.

As a material for the electron transport layer, known electron transport materials functioning to stably transport electrons injected from the cathode may be used. Examples of the known electron transport material may include materials such as quinoline derivatives, particularly tris(8-quinolinolato)aluminum (Alq₃), TAZ, BAlq, beryllium bis(benzoquinolin-10-olate) (Bebq₂) and oxadiazole derivatives (PBD, BMD, BND and the like).

In addition, each of the organic layers may be formed using a monomolecular deposition method or solution process. Herein, the monomolecular deposition method refers to a method of forming a thin film by evaporating a material used for forming each of the layers through heating and the like under vacuum or reduced pressure, and the solution process refers to a method of forming a thin film by mixing a material used for forming each of the layers with a solvent, and then applying a method such as ink-jet printing, roll-to-roll coating, screen printing, spray coating, dip coating or spin coating on the mixture.

In addition, the organic light-emitting device of the present invention may be used in devices selected from flat-panel display devices, flexible display devices, monochromatic or white flat-panel lighting devices, monochromatic or white flexible lighting devices, display devices for vehicles, display devices for virtual or augmented reality, and the like.

Hereinafter, preferred synthesis examples of compounds and device examples are provided in order to help understand the present invention. However, the following examples are for illustrative purposes only, and the scope of the present invention is not limited thereby.

### Synthesis Example 1: Synthesis of [ET-1]

### Synthesis Example 1-1: Synthesis of A-1

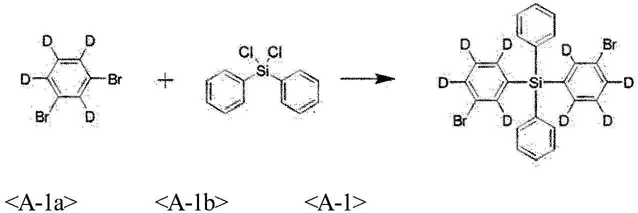

<A-1a> (39.8 g) and diethyl ether (398 mL) were introduced to a round bottom flask under nitrogen, and cooled to -78°C. Then, 1.6 M n-butyllithium (103.7 mL) was slowly added dropwise thereto, and the mixture solution was stirred. After 1 hour, <A-1b> (20 g) was introduced thereto, and the mixture solution was stirred for 12 hours at room temperature. After the reaction was terminated, the layers were separated using water and ethyl acetate. The organic layer was concentrated under reduced pressure, and then separated and purified by column chromatography to obtain <A-1> (25.4 g, 65%).

### Synthesis Example 1-2: Synthesis of A-2

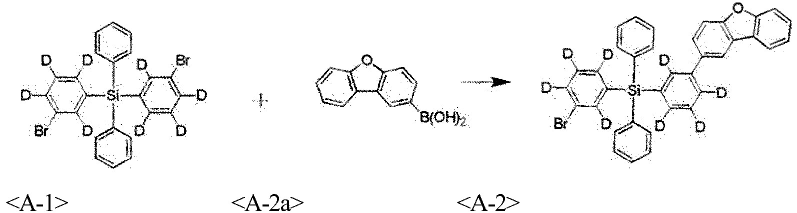

<A-1> (25.4 g), <A-2a> (11.8 g), (tetrakis(triphenylphosphine)palladium(0) (1.17 g), potassium carbonate (14 g), tetrahydrofuran (253 mL) and water (40 mL) were introduced to a round bottom flask under nitrogen, and the mixture solution was refluxed for 12 hours. After the reaction was terminated, the layers were separated, and dried with MgSO₄. The organic layer was concentrated under reduced pressure, and then separated and purified by column chromatography to obtain <A-2> (18.2 g, 61%).

### Synthesis Example 1-3: Synthesis of A-3

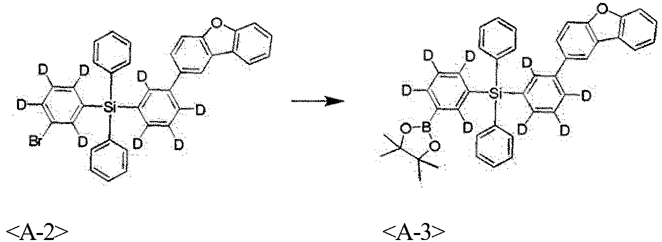

<A-2> (18.2 g), bis(pinacolato)diboron (10.2 g), [1,1'-bis(diphenylphosphino)ferrocene]dichloropalladium(II) (2.26 g), potassium acetate (9.09 g) and 1,4-dioxane (180 mL) were introduced to a round bottom flask under nitrogen, and the mixture solution was refluxed for 12 hours. After the reaction was terminated, the layers were separated and dried with MgSO₄. The organic layer was concentrated under reduced pressure, and then separated and purified by column chromatography to obtain <A-3> (16 g, 91%).

### Synthesis Example 1-4: Synthesis of [ET-1]

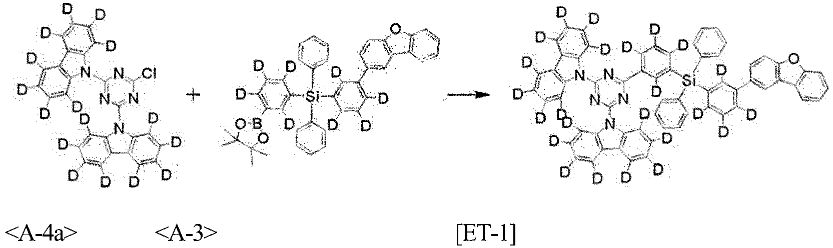

<A-4a> (11 g), <A-3> (16 g), tetrakis(triphenylphosphine)palladium(0) (1.38 g), potassium carbonate (8.23 g), 1,4-dioxane (150 mL) and water (25 mL) were introduced to a round bottom flask under nitrogen, and the mixture solution was refluxed for 12 hours. After the reaction was terminated, the layers were separated and dried with MgSO₄. The organic layer was concentrated under reduced pressure, and then separated and purified by column chromatography to obtain [ET-1] (14.5 g, 65%).
MS (MALDI-TOF): m/z 935.46 [M⁺]

### Synthesis Example 2: Synthesis of [ET-2]

### Synthesis Example 2-1: Synthesis of B-1

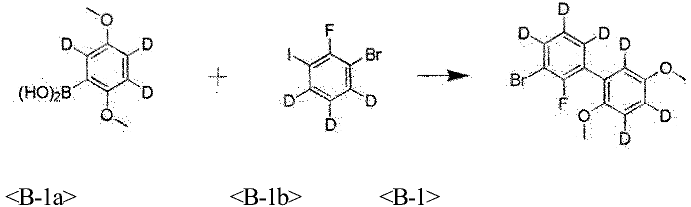

<B-1> was obtained by performing a synthesis in the same manner as in Synthesis Example 1-4, except that<B-1 b> was used instead of <A-4a>, and <B-1a> was used instead of <A-3>. (Yield 80%)

### Synthesis Example 2-2: Synthesis of B-2

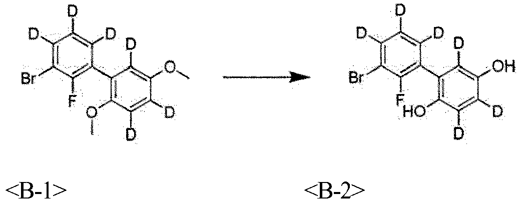

<B-1> (50 g) and dichloromethane (500 mL) were introduced to a round bottom flask under nitrogen, and cooled to 0°C. Then, boron tribromide (45 mL) was slowly added dropwise thereto, and the mixture solution was stirred for 12 hours at room temperature. After the reaction was terminated, the layers were separated, dried with MgSO₄, concentrated under reduced pressure, and separated and purified by column chromatography to obtain <B-2> (36.9 g, 81%).

### Synthesis Example 2-3: Synthesis of B-3

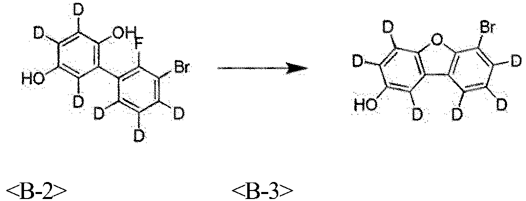

<B-2> (36.9 g), potassium carbonate (52.9 g) and dimethylformamide (370 mL) were introduced to a round bottom flask under nitrogen, and the mixture solution was refluxed for 12 hours. After the reaction was terminated, the layers were separated, dried with MgSO₄, concentrated under reduced pressure, and separated and purified by column chromatography to obtain <B-3> (29.2 g, 85%).

### Synthesis Example 2-4: Synthesis of B-4

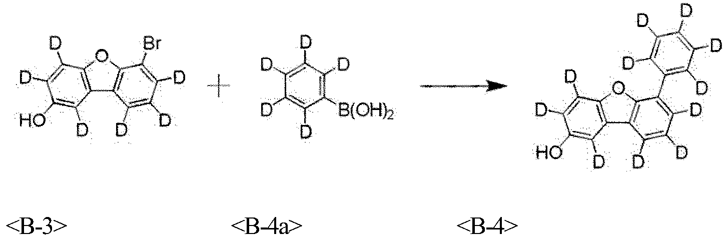

<B-4> was obtained by performing a synthesis in the same manner as in Synthesis Example 1-4, except that <B-3> was used instead of <A-4a>, and <B-4a> was used instead of <A-3>. (Yield 82%)

### Synthesis Example 2-5: Synthesis of B-5

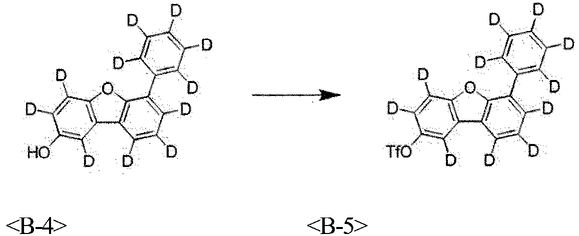

<B-4> (25 g) and pyridine (10.9 g) were introduced to a round bottom flask under nitrogen, and cooled to -10°C. Then, trifluoromethanesulfonic anhydride (39 g) was slowly added dropwise thereto, and the mixture solution was stirred for 12 hours at room temperature. After the reaction was terminated, the layers were separated, dried with MgSO₄, and then separated and purified by column chromatography to obtain <B-5> (31.2 g, 84%).

### Synthesis Example 2-6: Synthesis of B-6

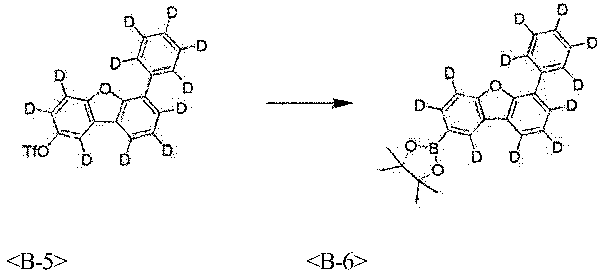

<B-6> was obtained by performing a synthesis in the same manner as in Synthesis Example 1-3, except that <B-5> was used instead of <A-2>. (Yield 78%)

### Synthesis Example 2-7: Synthesis of B-7

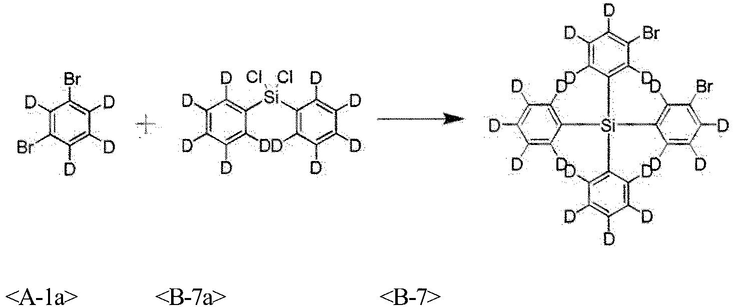

<B-7> was obtained by performing a synthesis in the same manner as in Synthesis Example 1-1, except that <B-7a> was used instead of <A-1b>. (Yield 63%)

### Synthesis Example 2-8: Synthesis of B-8

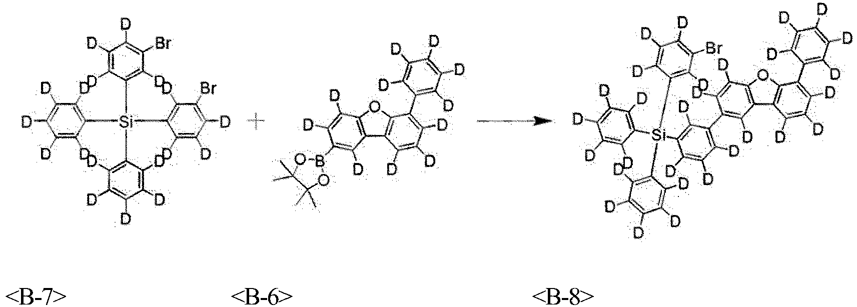

<B-8> was obtained by performing a synthesis in the same manner as in Synthesis Example 1-2, except that <B-7> was used instead of <A-1>, and <B-6> was used instead of <A-2a>. (Yield 56%)

### Synthesis Example 2-9: Synthesis of B-9

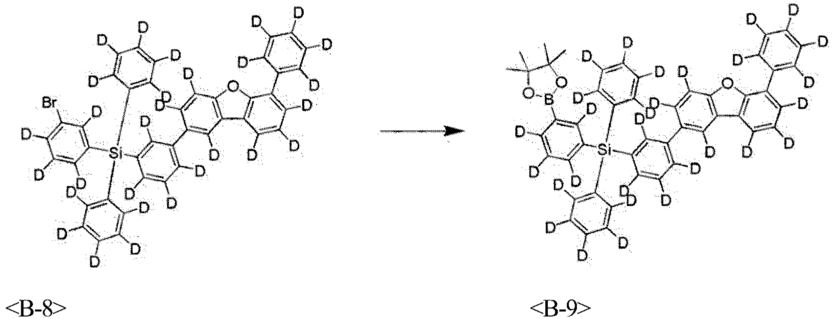

<B-9> was obtained by performing a synthesis in the same manner as in Synthesis Example 1-3, except that <B-8> was used instead of <A-2>. (Yield 79%)

### Synthesis Example 2-10: Synthesis of ET-2

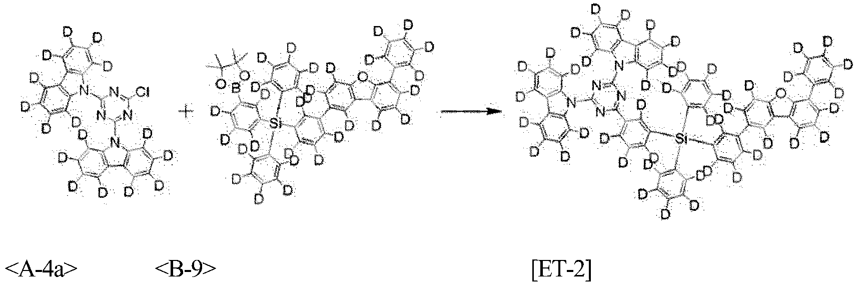

[ET-2] was obtained by performing a synthesis in the same manner as in Synthesis Example 1-4, except that <B-9> was used instead of <A-3>. (Yield 78%)
MS (MALDI-TOF): m/z 1032.62 [M⁺]

### Synthesis Example 3: Synthesis of [ET-3]

### Synthesis Example 3-1: Synthesis of C-1

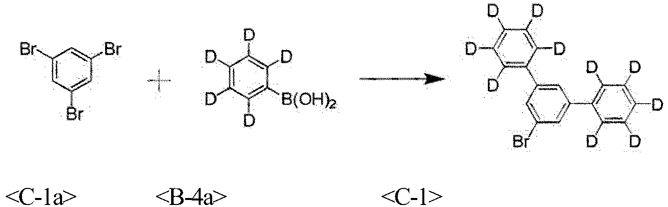

<C-1> was obtained by performing a synthesis in the same manner as in Synthesis Example 1-2, except that <C-1 a> was used instead of <A-1>, and <B-4a> was used instead of <A-2a>. (Yield 60%)

### Synthesis Example 3-2: Synthesis of C-2

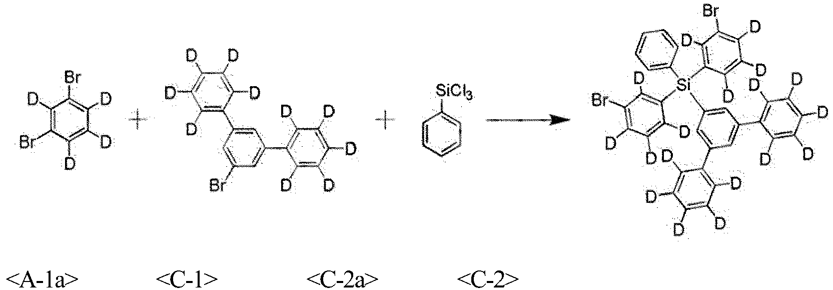

<A-1a> (35.7 g) and diethyl ether (360 mL) were introduced to a round bottom flask under nitrogen and cooled to -78°C, and a 1.6 M n-butyllithium solution (102 mL) was slowly added dropwise thereto. <C-1> (24.9 g) and diethyl ether (250 mL) were introduced to another round bottom flask under nitrogen and cooled to -78°C, and a 1.6 M n-butyllithium solution (53.6 mL) was slowly added dropwise thereto. Both of the solutions were stirred for 1 hour. The above two reaction solutions were sequentially added dropwise to a round bottom flask containing a solution, in which <C-2a> (15 g) was dissolved in diethyl ether (75 mL), cooled to -78°C, and the mixture solution was stirred for 12 hours at room temperature. After the reaction was terminated, the layers were separated. The organic layer was concentrated under reduced pressure, and then separated and purified by column chromatography to obtain <C-2> (25.1 g, 60%).

### Synthesis Example 3-3: Synthesis of C-3

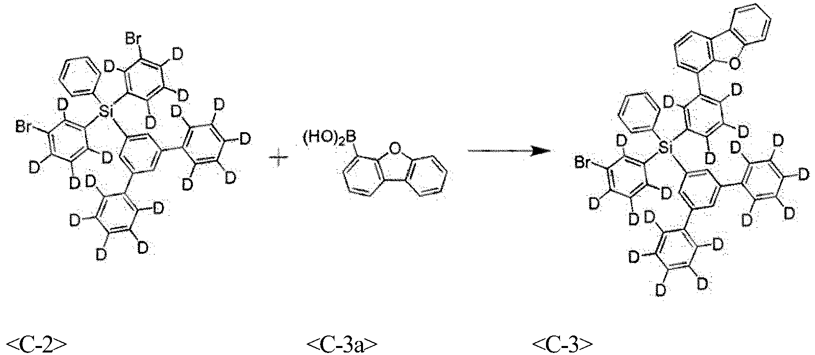

<C-3> was obtained by performing a synthesis in the same manner as in Synthesis Example 1-2, except that <C-2> was used instead of <A-1>, and <C-3a> was used instead of <A-2a>. (Yield 58%)

### Synthesis Example 3-4: Synthesis of C-4

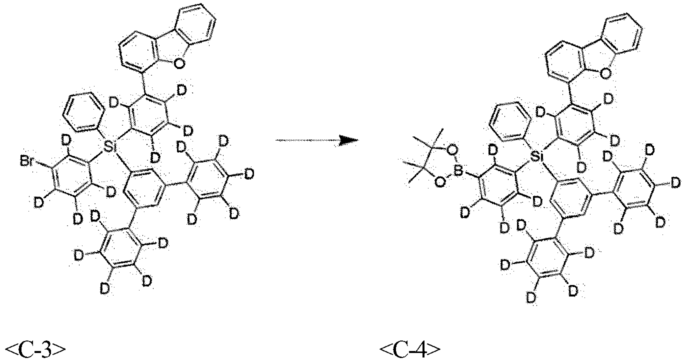

<C-4> was obtained by performing a synthesis in the same manner as in Synthesis Example 1-3, except that <C-3> was used instead of <A-2>. (Yield 80%)

### Synthesis Example 3-5: Synthesis of [ET-3]

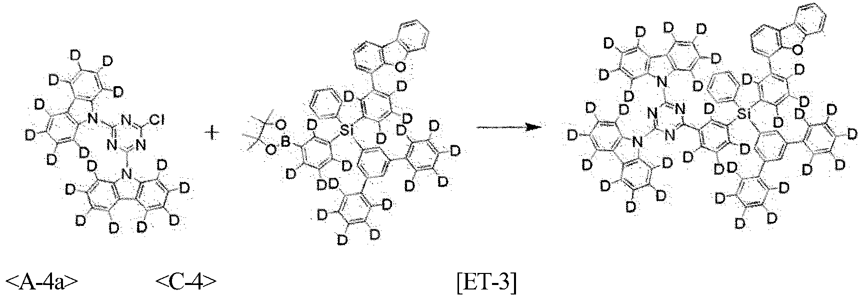

[ET-3] was obtained by performing a synthesis in the same manner as in Synthesis Example 1-4, except that <C-4> was used instead of <A-3>. (Yield 69%)
MS (MALDI-TOF): m/z 1097.58 [M⁺]

### Synthesis Example 4: Synthesis of [ET-4]

### Synthesis Example 4-1: Synthesis of D-1

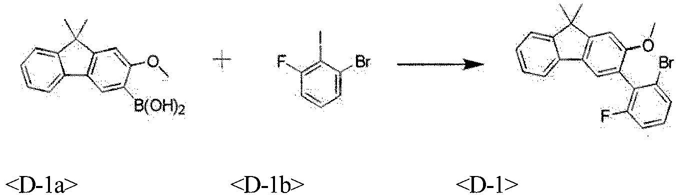

<D-1> was obtained by performing a synthesis in the same manner as in Synthesis Example 1-2, except that <D-1 a> was used instead of <A-2a>, and <D-1b> was used instead of <A-1>. (Yield 66%)

### Synthesis Example 4-2: Synthesis of D-2

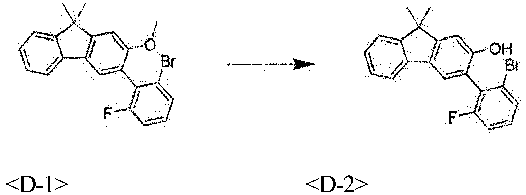

<D-2> was obtained by performing a synthesis in the same manner as in Synthesis Example 2-2, except that <D-1> was used instead of <B-1>. (Yield 88%)

### Synthesis Example 4-3: Synthesis of D-3

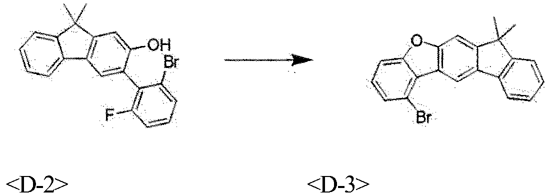

<D-3> was obtained by performing a synthesis in the same manner as in Synthesis Example 2-3, except that <D-2> was used instead of <B-2>. (Yield 78%)

### Synthesis Example 4-4: Synthesis of D-4

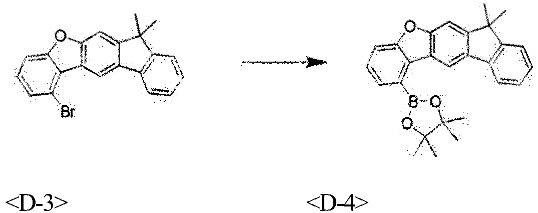

<D-4> was obtained by performing a synthesis in the same manner as in Synthesis Example 1-3, except that <D-3> was used instead of <A-2>. (Yield 75%)

### Synthesis Example 4-5: Synthesis of D-5

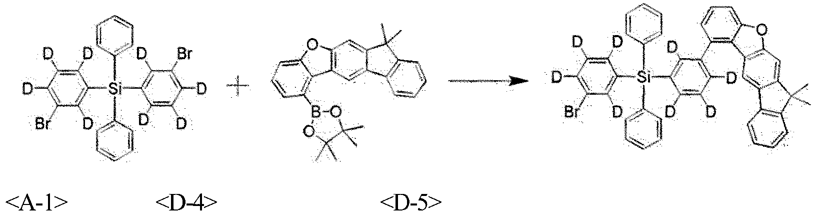

<D-5> was obtained by performing a synthesis in the same manner as in Synthesis Example 1-2, except that <D-4> was used instead of <A-2a>. (Yield 59%)

### Synthesis Example 4-6: Synthesis of D-6

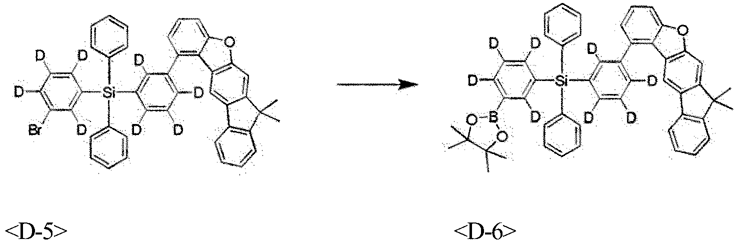

<D-6> was obtained by performing a synthesis in the same manner as in Synthesis Example 1-3, except that <D-5> was used instead of <A-2>. (Yield 77%)

### Synthesis Example 4-7: Synthesis of [ET-4]

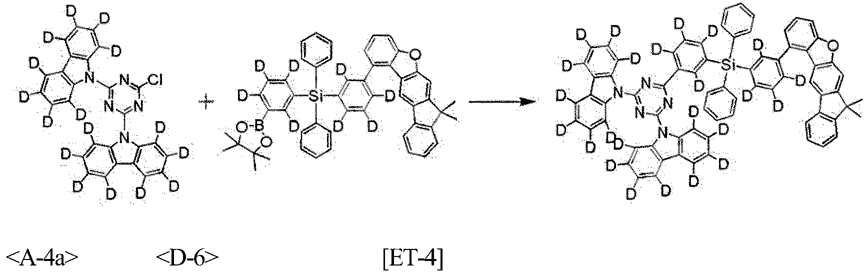

[ET-4] was obtained by performing a synthesis in the same manner as in Synthesis Example 1-4, except that <D-6> was used instead of <A-3>. (Yield 66%)
MS (MALDI-TOF): m/z 1051.52 [M⁺]

### Synthesis Example 5: Synthesis of [ET-5]

### Synthesis Example 5-1: Synthesis of E-1

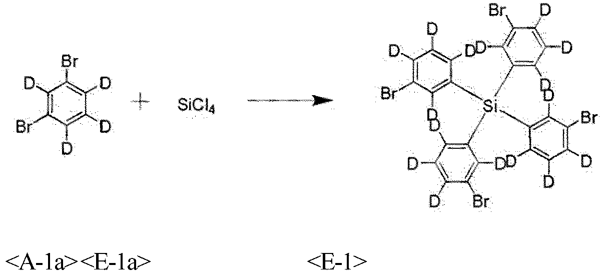

<E-1> was obtained by performing a synthesis in the same manner as in Synthesis Example 1-1, except that <E-1a> was used instead of <A-1b>. (Yield 65%)

### Synthesis Example 5-2: Synthesis of E-2

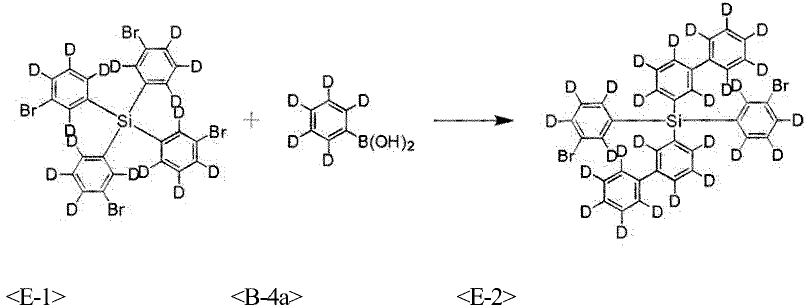

<E-2> was obtained by performing a synthesis in the same manner as in Synthesis Example 1-2, except that <E-1> was used instead of <A-1>, and <B-4a> was used instead of <A-2a>. (Yield 61%)

### Synthesis Example 5-3: Synthesis of E-3

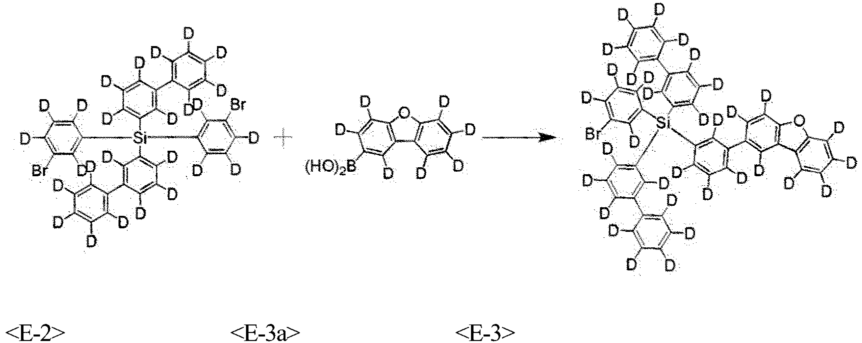

<E-3> was obtained by performing a synthesis in the same manner as in Synthesis Example 1-2, except that <E-2> was used instead of <A-1>, and <E-3a> was used instead of <A-2a>. (Yield 57%)

### Synthesis Example 5-4: Synthesis of E-4

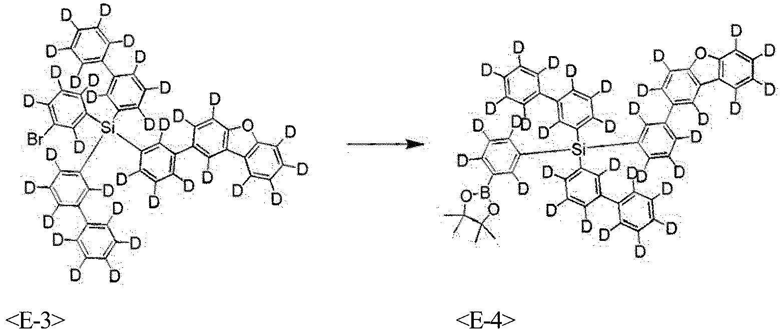

<E-4> was obtained by performing a synthesis in the same manner as in Synthesis Example 1-3, except that <E-3> was used instead of <A-2>. (Yield 78%)

### Synthesis Example 5-5: Synthesis of [ET-5]

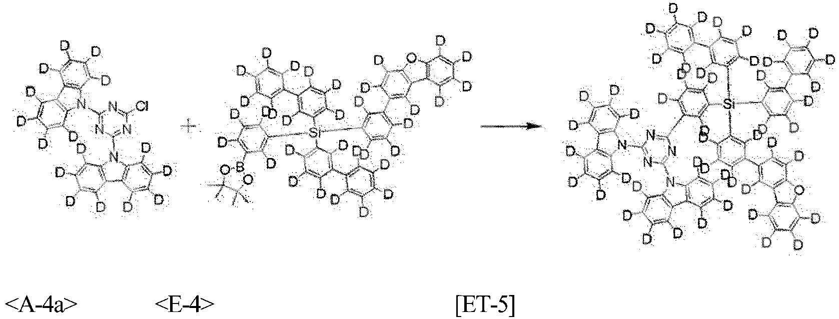

[ET-5] was obtained by performing a synthesis in the same manner as in Synthesis Example 1-4, except that <E-4> was used instead of <A-3>. (Yield 68%)
MS (MALDI-TOF): m/z 1112.68 [M⁺]

### Synthesis Example 6: Synthesis of [ET-6]

### Synthesis Example 6-1: Synthesis of F-1

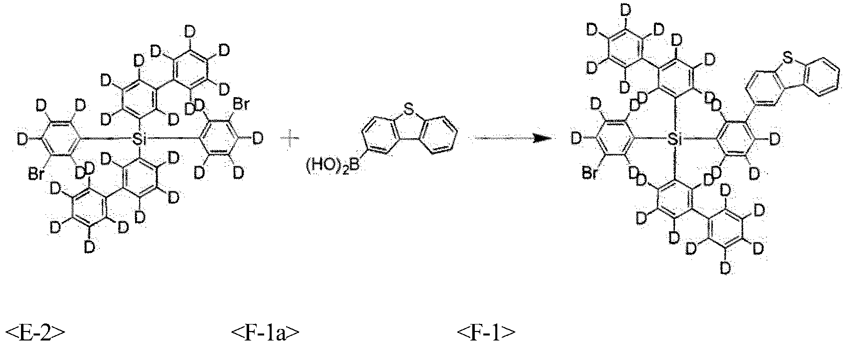

<F-1> was obtained by performing a synthesis in the same manner as in Synthesis Example 1-2, except that <E-2> was used instead of <A-1>, and <F-la> was used instead of <A-2a>. (Yield 55%)

### Synthesis Example 6-2: Synthesis of F-2

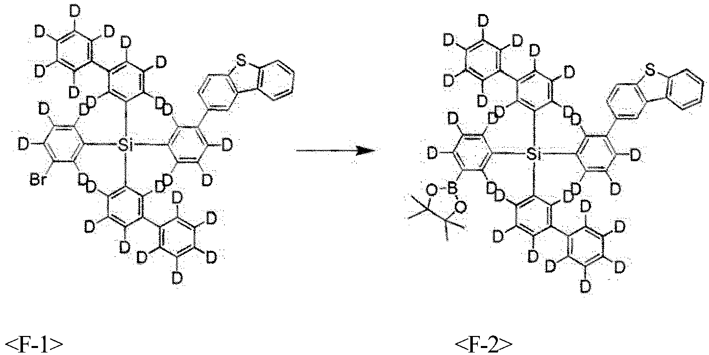

<F-2> was obtained by performing a synthesis in the same manner as in Synthesis Example 1-3, except that <F-1> was used instead of <A-2>. (Yield 74%)

### Synthesis Example 6-3: Synthesis of [ET-6]

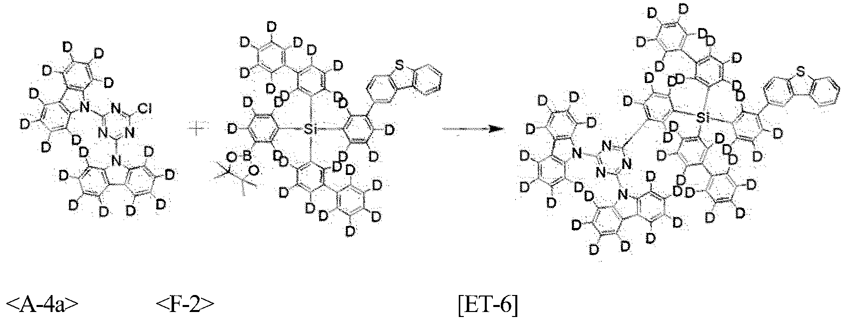

[ET-6] was obtained by performing a synthesis in the same manner as in Synthesis Example 1-4, except that <F-2> was used instead of <A-3>. (Yield 64%)
MS (MALDI-TOF): m/z 1121.61 [M⁺]

### Synthesis Example 7: Synthesis of [ET-7]

### Synthesis Example 7-1: Synthesis of G-1

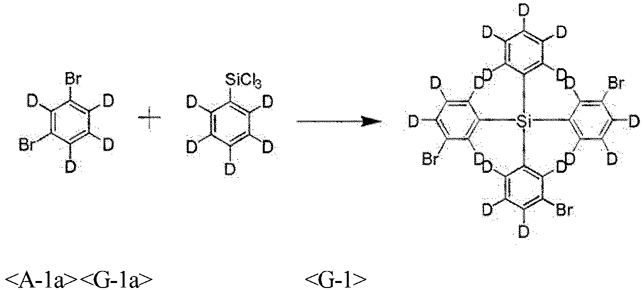

<G-1> was obtained by performing a synthesis in the same manner as in Synthesis Example 1-1, except that <G-la> was used instead of <A-1b>. (Yield 64%)

### Synthesis Example 7-2: Synthesis of G-2

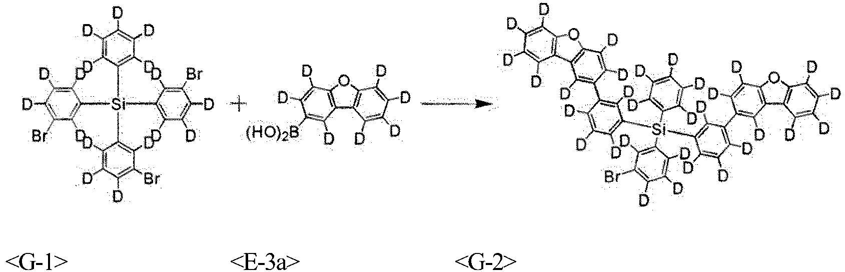

<G-2> was obtained by performing a synthesis in the same manner as in Synthesis Example 1-2, except that <G-1> was used instead of <A-1>, and <E-3a> was used instead of <A-2a>. (Yield 61%)

### Synthesis Example 7-3: Synthesis of G-3

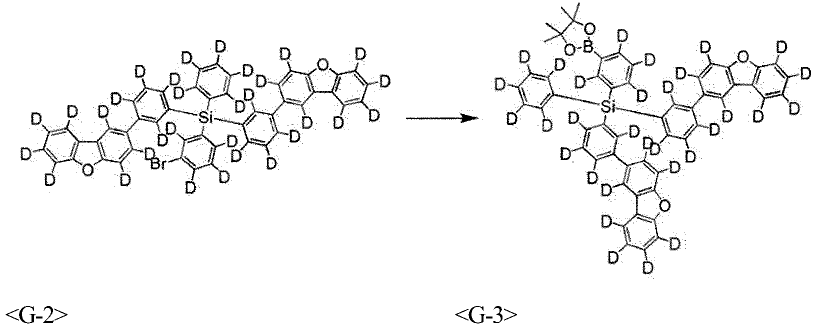

<G-3> was obtained by performing a synthesis in the same manner as in Synthesis Example 1-3, except that <G-2> was used instead of <A-2>. (Yield 74%)

### Synthesis Example 7-4: Synthesis of [ET-7]

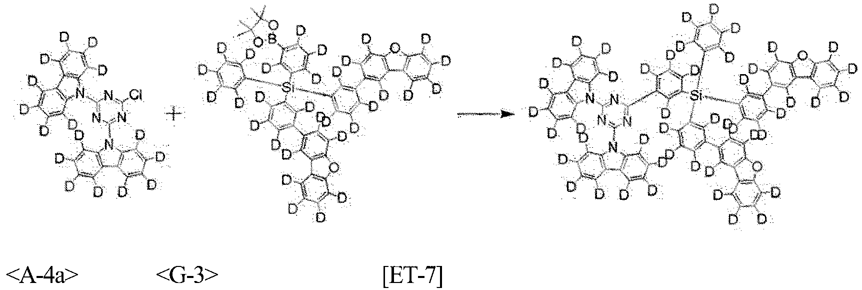

[ET-7] was obtained by performing a synthesis in the same manner as in Synthesis Example 1-4, except that <G-3> was used instead of <A-3>. (Yield 66%)
MS (MALDI-TOF): m/z 1124.64 [M⁺]

### Synthesis Example 8: Synthesis of [ET-8]

### Synthesis Example 8-1: Synthesis of H-1

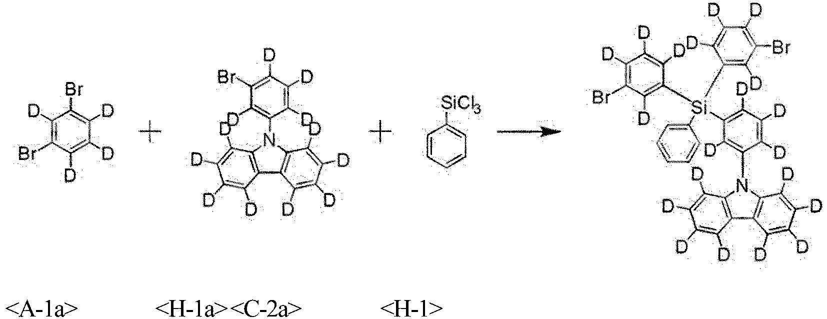

<H-1> was obtained by performing a synthesis in the same manner as in Synthesis Example 3-2, except that <H-la> was used instead of <C-1>. (Yield 52%)

### Synthesis Example 8-2: Synthesis of H-2

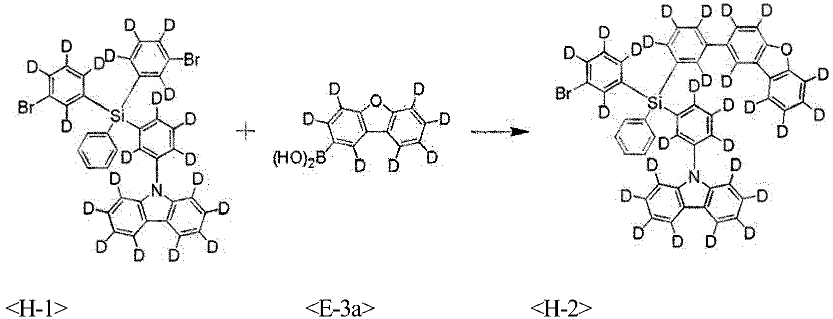

<H-2> was obtained by performing a synthesis in the same manner as in Synthesis Example 1-2, except that <H-1> was used instead of <A-1>, and <E-3a> was used instead of <A-2a>. (Yield 63%)

### Synthesis Example 8-3: Synthesis of H-3

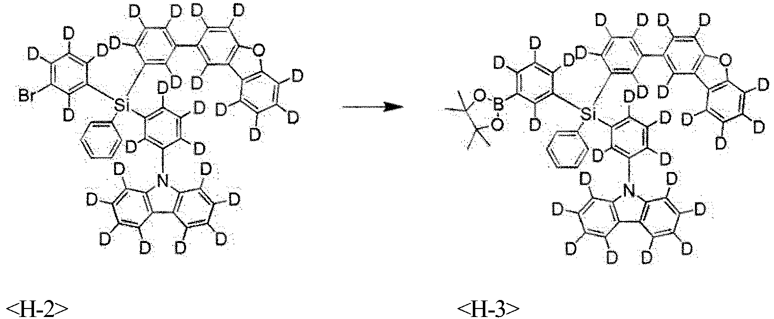

<H-3> was obtained by performing a synthesis in the same manner as in Synthesis Example 1-3, except that <H-2> was used instead of <A-2>. (Yield 74%)

### Synthesis Example 8-4: Synthesis of [ET-8]

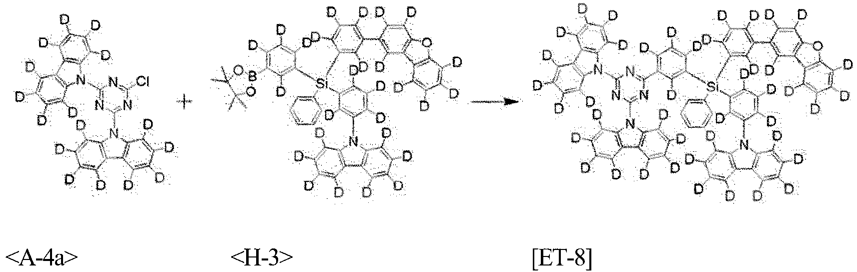

[ET-8] was obtained by performing a synthesis in the same manner as in Synthesis Example 1-4, except that <H-3> was used instead of <A-3>. (Yield 63%)
MS (MALDI-TOF): m/z 1119.64 [M⁺]

### Synthesis Example 9: Synthesis of [ET-9]

### Synthesis Example 9-1: Synthesis of I-1

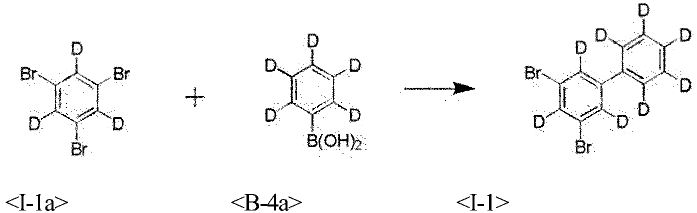

<I-1> was obtained by performing a synthesis in the same manner as in Synthesis Example 1-2, except that <I-1a> was used instead of <A-1>, and <B-4a> was used instead of <A-2a>. (Yield 59%)

### Synthesis Example 9-2: Synthesis of I-2

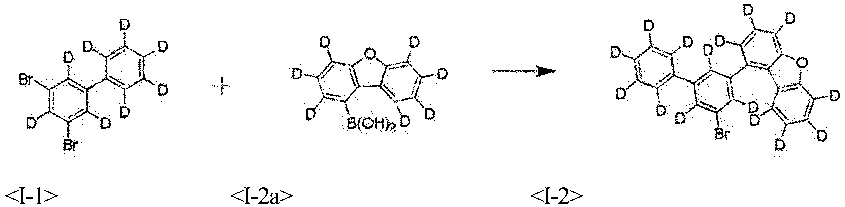

<I-2> was obtained by performing a synthesis in the same manner as in Synthesis Example 1-2, except that <I-1 > was used instead of <A-1>, and <I-2a> was used instead of <A-2a>. (Yield 61%)

### Synthesis Example 9-3: Synthesis of I-3

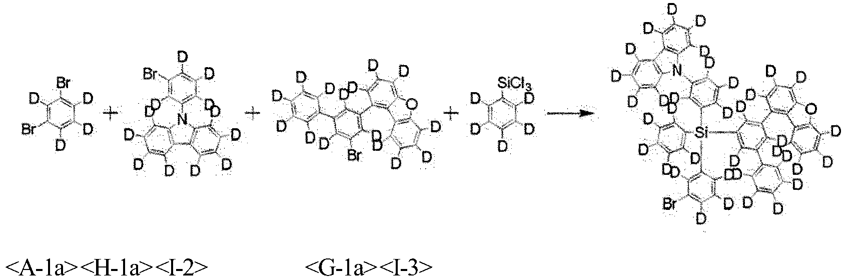

<A-1a> (16.6 g) and ethyl ether (170 mL) were introduced to a round bottom flask under nitrogen and cooled to -78°C, and a 1.6 M n-butyllithium solution (47.6 mL) was slowly added dropwise thereto. <H-1a> (25.47 g) and diethyl ether (250 mL) were introduced to another round bottom flask under nitrogen and cooled to -78°C, and a 1.6 M n-butyllithium solution (166 mL) was slowly added dropwise thereto. <I-2> (31.57 g) and diethyl ether (320 mL) were introduced to still another round bottom flask under nitrogen and cooled to -78°C, and a 1.6 M n-butyllithium solution (52.38 mL) was slowly added dropwise thereto. All the solutions were stirred for 1 hour. The above three reaction solutions were sequentially added dropwise to a round bottom flask containing a solution, in which <G-1a> (15 g) was dissolved in ether (75 mL), cooled to -78°C, and the mixture solution was stirred for 12 hours at room temperature. After the reaction was terminated, the layers were separated. The organic layer was concentrated under reduced pressure, and then separated and purified by column chromatography to obtain <I-3> (23.8 g, 50%).

### Synthesis Example 9-4: Synthesis of I-4

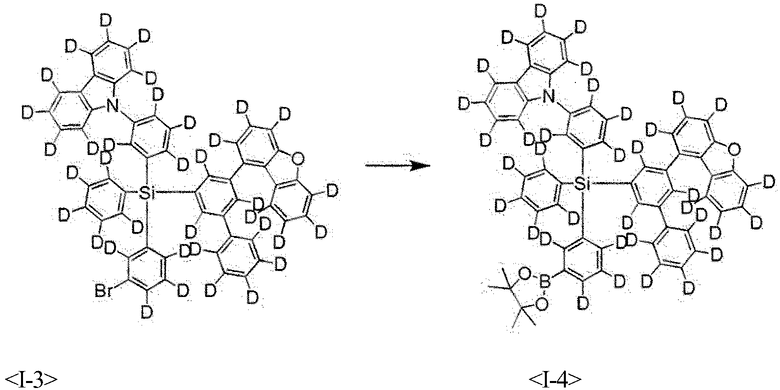

<I-4> was obtained by performing a synthesis in the same manner as in Synthesis Example 1-3, except that <I-3> was used instead of <A-2>. (Yield 71%)

### Synthesis Example 9-5: Synthesis of [ET-9]

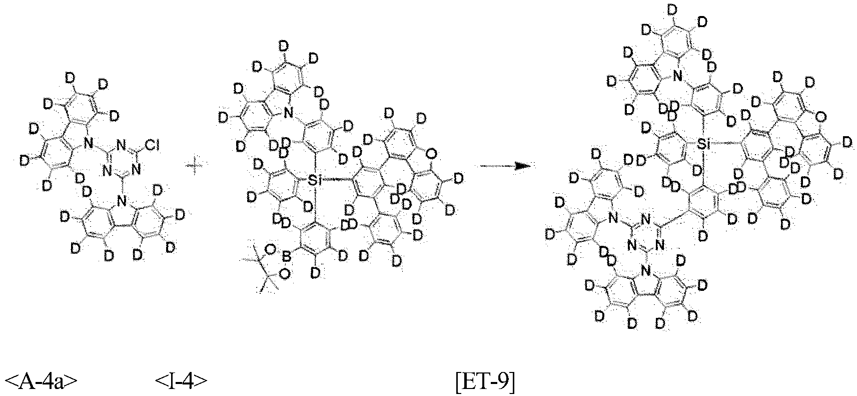

[ET-9] was obtained by performing a synthesis in the same manner as in Synthesis Example 1-4, except that <I-4> was used instead of <A-3>. (Yield 62%)
MS (MALDI-TOF): m/z 1204.72 [M⁺]

### Synthesis Example 10: Synthesis of [ET-10]

### Synthesis Example 10-1: Synthesis of J-1

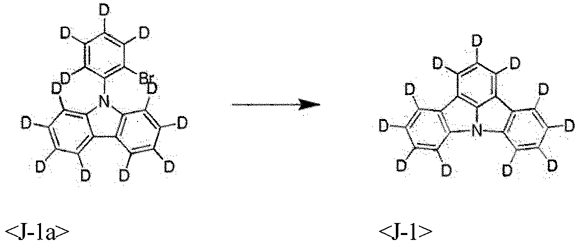

<J-1a> (60 g), palladium acetate (4 g), tricyclohexylphosphine (10 g) and dimethylacetamide (600 mL) were introduced to a round bottom flask under nitrogen, and the mixture solution was refluxed for 12 hours. After the reaction was terminated, the layers were separated, dried with MgSO₄, then concentrated under reduced pressure, and separated and purified by column chromatography to obtain <J-1> (31.7 g, 70%).

### Synthesis Example 10-2: Synthesis of J-2

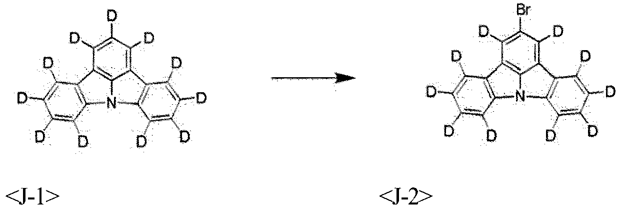

<J-1> (31.7 g) and dimethylformamide (320 mL) were introduced to a round bottom flask under nitrogen, and cooled to -10°C. Then, N-bromosuccinimide (22.4 g) and dimethylformamide (100 mL) were slowly added dropwise thereto, and the mixture solution was stirred for 12 hours at room temperature. After the reaction was terminated, the layers were separated, dried with MgSO₄, then concentrated under reduced pressure, and separated and purified by column chromatography to obtain <J-2> (33.2 g, 80%).

### Synthesis Example 10-3: Synthesis of J-3

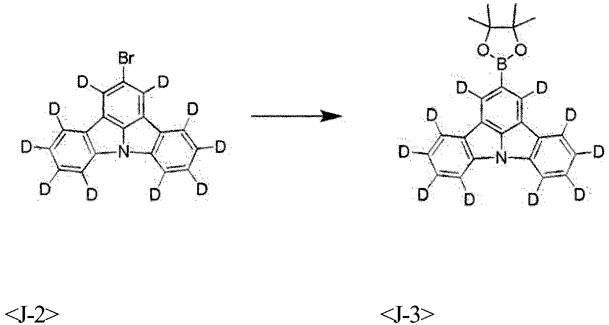

<J-3> was obtained by performing a synthesis in the same manner as in Synthesis Example 1-3, except that <J-2> was used instead of <A-2>. (Yield 71%)

### Synthesis Example 10-4: Synthesis of J-4

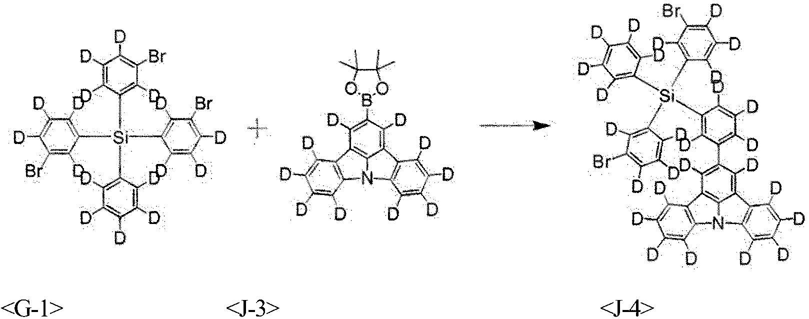

<J-4> was obtained by performing a synthesis in the same manner as in Synthesis Example 1-2, except that <G-1 > was used instead of <A-1 >, and <J-3> was used instead of <A-2a>. (Yield 50%)

### Synthesis Example 10-5: Synthesis of J-5

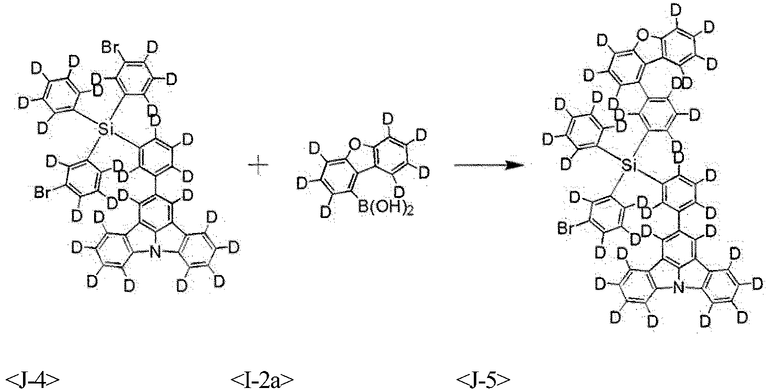

<J-5> was obtained by performing a synthesis in the same manner as in Synthesis Example 1-2, except that <J-4> was used instead of <A-1 >, and <I-2a> was used instead of <A-2a>. (Yield 54%)

### Synthesis Example 10-6: Synthesis of J-6

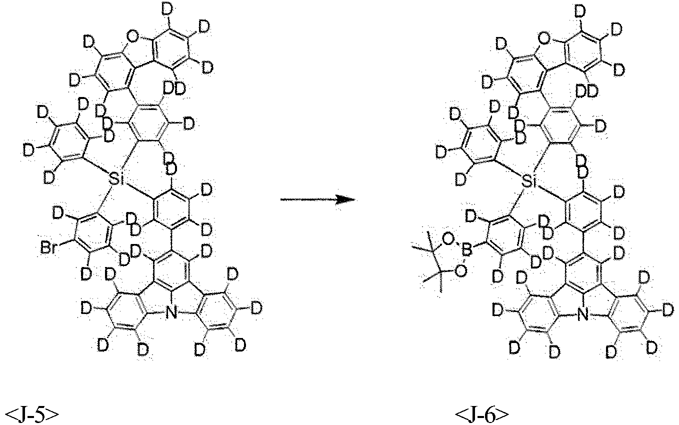

<J-6> was obtained by performing a synthesis in the same manner as in Synthesis Example 1-3, except that <J-5> was used instead of <A-2>. (Yield 69%)

### Synthesis Example 10-7: Synthesis of [ET-10]

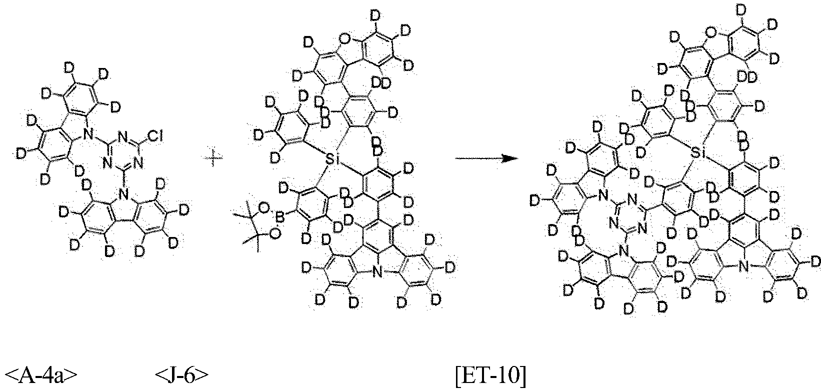

[ET-10] was obtained by performing a synthesis in the same manner as in Synthesis Example 1-4, except that <J-6> was used instead of <A-3>. (Yield 66%)
MS (MALDI-TOF): m/z 1200.70 [M⁺]

### Synthesis Example 11: Synthesis of [ET-11]

### Synthesis Example 11-1: Synthesis of K-1

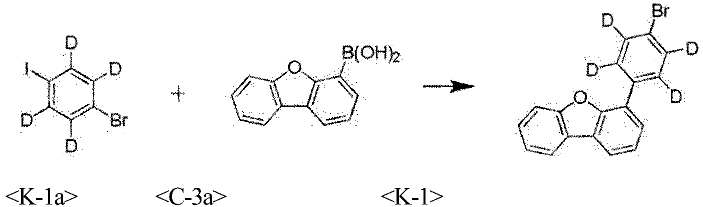

<K-1> was obtained by performing a synthesis in the same manner as in Synthesis Example 1-2, except that <K-1a> was used instead of <A-1>, and <C-3a> was used instead of <A-2a>. (Yield 68%)

### Synthesis Example 11-2: Synthesis of K-2

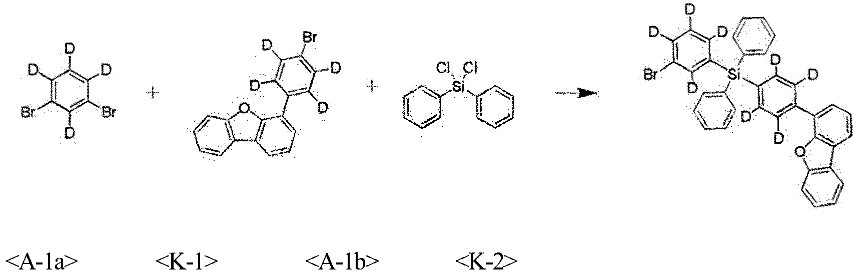

<K-2> was obtained by performing a synthesis in the same manner as in Synthesis Example 3-2, except that <K-1> was used instead of <C-1>, and <A-1b> was used instead of <C-1a>. (Yield 56%)

### Synthesis Example 11-3: Synthesis of K-3

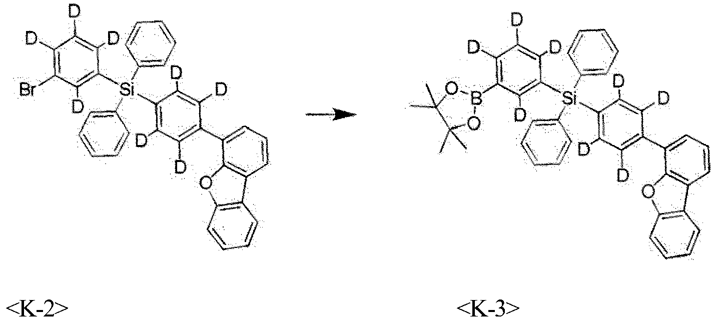

<K-3> was obtained by performing a synthesis in the same manner as in Synthesis Example 1-3, except that <K-2> was used instead of <A-2>. (Yield 75%)

### Synthesis Example 11-4: Synthesis of [ET- 11]

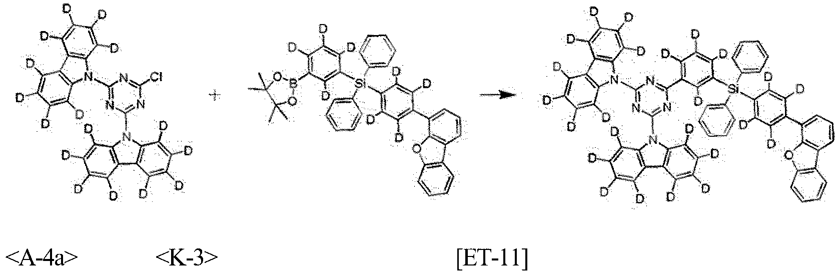

[ET-11] was obtained by performing a synthesis in the same manner as in Synthesis Example 1-4, except that <K-3> was used instead of <A-3>. (Yield 63%)
MS (MALDI-TOF): m/z 935.46 [M⁺]

### Synthesis Example 12: Synthesis of [ET-12]

### Synthesis Example 12-1: Synthesis of L-1

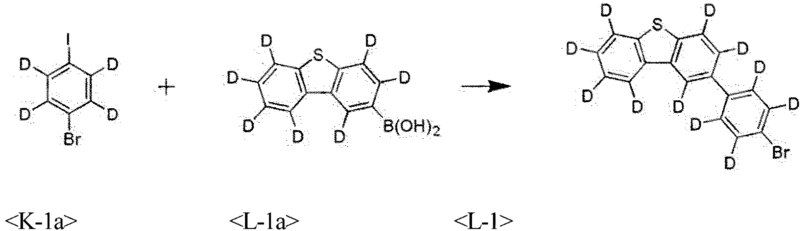

<L-1> was obtained by performing a synthesis in the same manner as in Synthesis Example 1-2, except that <K-1a> was used instead of <A-1>, and <L-1a> was used instead of <A-2a>. (Yield 73%)

### Synthesis Example 12-2: Synthesis of L-2

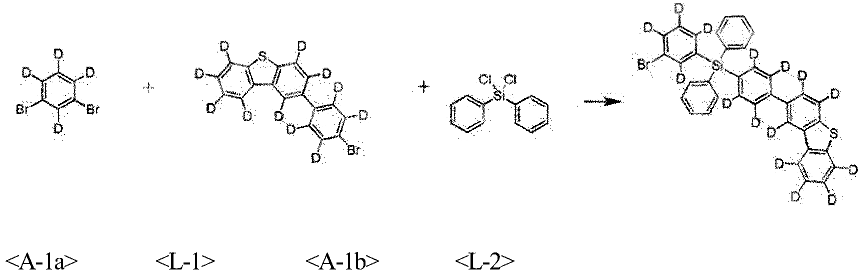

<L-2> was obtained by performing a synthesis in the same manner as in Synthesis Example 11-2, except that <L-1> was used instead of <K-1>. (Yield 58%)

### Synthesis Example 12-3: Synthesis of L-3

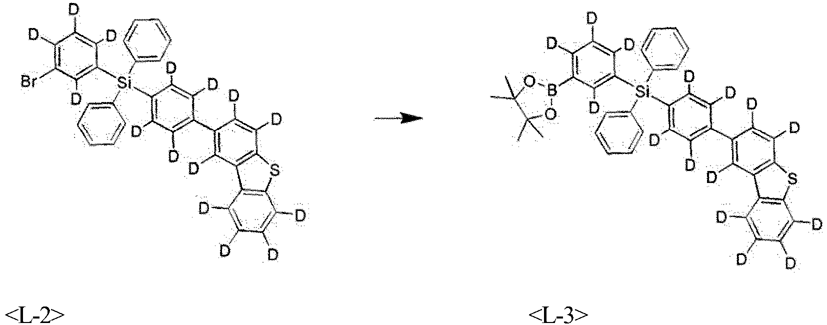

<L-3> was obtained by performing a synthesis in the same manner as in Synthesis Example 1-3, except that <L-2> was used instead of <A-2>. (Yield 74%)

### Synthesis Example 12-4: Synthesis of [ET-12]

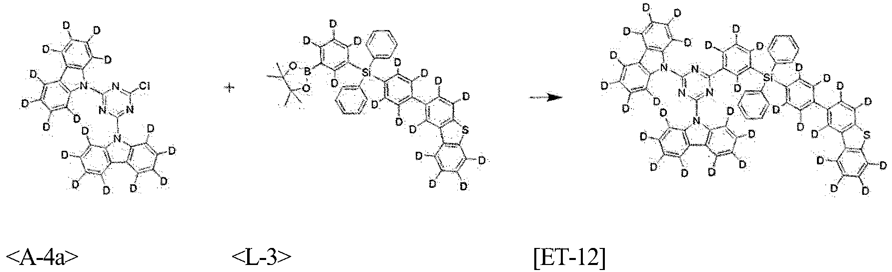

[ET-12] was obtained by performing a synthesis in the same manner as in Synthesis Example 1-4, except that <L-3> was used instead of <A-3>. (Yield 65%)
MS (MALDI-TOF): m/z 958.48 [M⁺]

### Synthesis Example 13: Synthesis of [ET-13]

### Synthesis Example 13-1: Synthesis of M-1

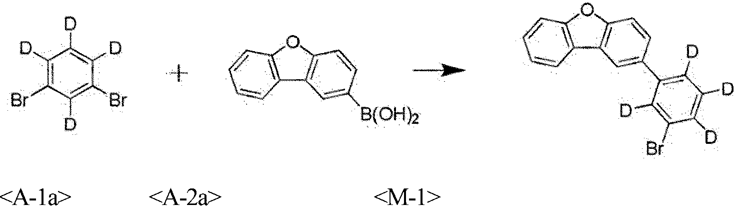

<M-1> was obtained by performing a synthesis in the same manner as in Synthesis Example 1-2, except that <A-1a> was used instead of <A-1>. (Yield 65%)

### Synthesis Example 13-2: Synthesis of M-2

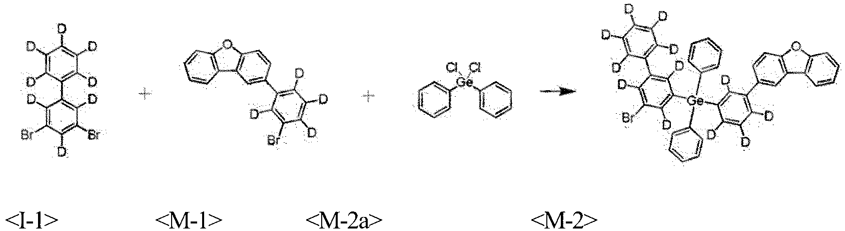

<M-2> was obtained by performing a synthesis in the same manner as in Synthesis Example 11-2, except that <I-1> was used instead of <A-1a>, <M-1> was used instead of <K-1>, and <M-2a> was used instead of <A-1b>. (Yield 55%)

### Synthesis Example 13-3: Synthesis of M-3

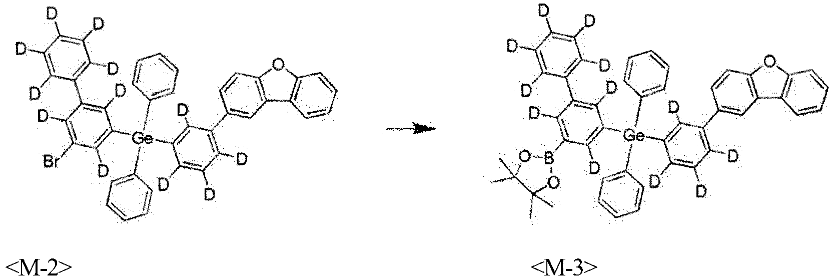

<M-3> was obtained by performing a synthesis in the same manner as in Synthesis Example 1-3, except that <M-2> was used instead of <A-2>. (Yield 77%)

### Synthesis Example 13-4: Synthesis of [ET-13]

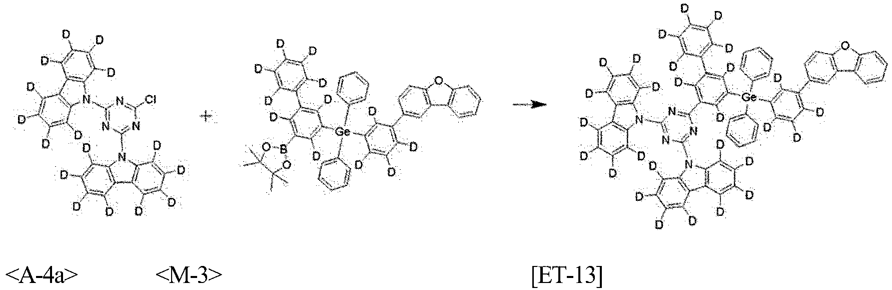

[ET-13] was obtained by performing a synthesis in the same manner as in Synthesis Example 1-4, except that <M-3> was used instead of <A-3>. (Yield 63%)
MS (MALDI-TOF): m/z 1061.46 [M⁺]

### Synthesis Example 14: Synthesis of [ET-14]

### Synthesis Example 14-1: Synthesis of N-1

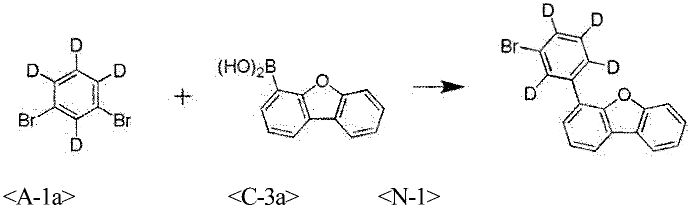

<N-1> was obtained by performing a synthesis in the same manner as in Synthesis Example 1-2, except that <A-1a> was used instead of <A-1>, and <C-3a> was used instead of <A-2a>. (Yield 62%)

### Synthesis Example 14-2: Synthesis of N-2

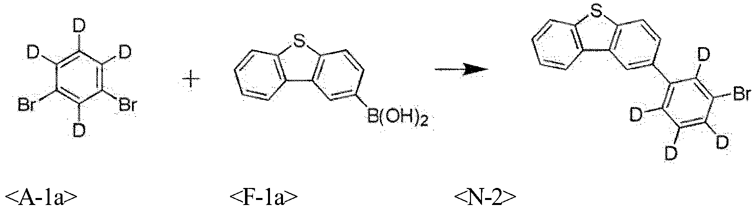

<N-2> was obtained by performing a synthesis in the same manner as in Synthesis Example 1-2, except that <A-1a> was used instead of <A-1>, and <F-1a> was used instead of <A-2a>. (Yield 61%)

### Synthesis Example 14-3: Synthesis ofN-3

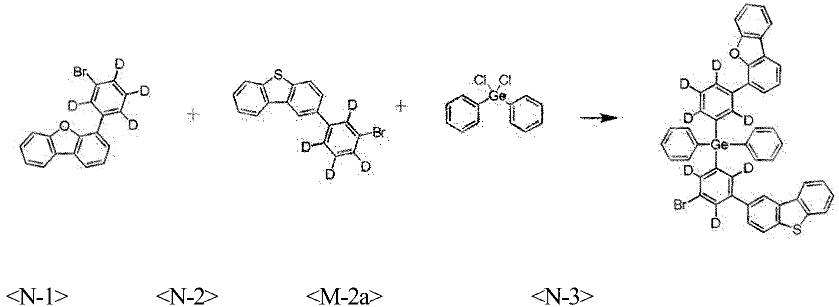

<N-3> was obtained by performing a synthesis in the same manner as in Synthesis Example 11-2, except that <N-1> was used instead of <A-1a>, <N-2> was used instead of <K-1>, and <M-2a> was used instead of <A-1b>. (Yield 60%)

### Synthesis Example 14-4: Synthesis ofN-4

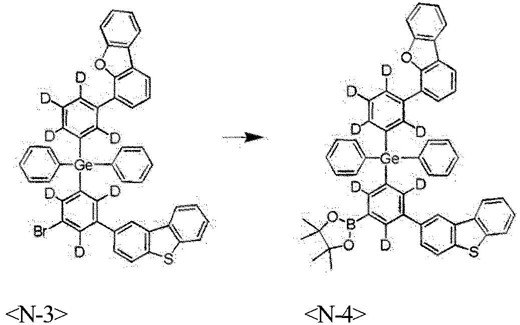

<N-4> was obtained by performing a synthesis in the same manner as in Synthesis Example 1-3, except that <N-3> was used instead of <A-2>. (Yield 79%)

### Synthesis Example 14-5: Synthesis of [ET-14]

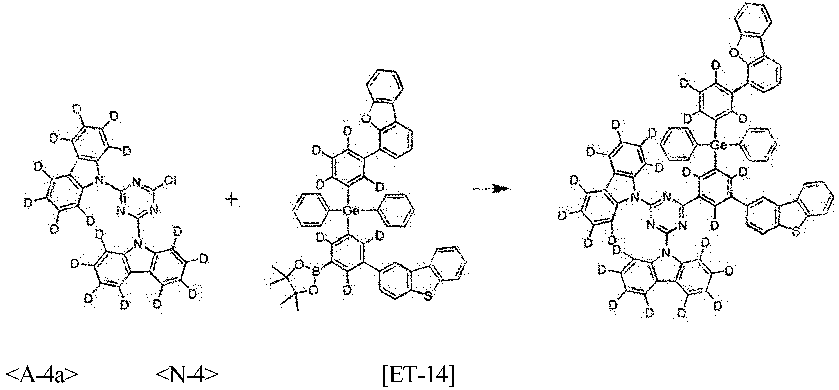

[ET-14] was obtained by performing a synthesis in the same manner as in Synthesis Example 1-4, except that <N-4> was used instead of <A-3>. (Yield 62%)
MS (MALDI-TOF): m/z 1162.42 [M⁺]

### Synthesis Example 15: Synthesis of [ET-15]

### Synthesis Example 15-1: Synthesis of O-1

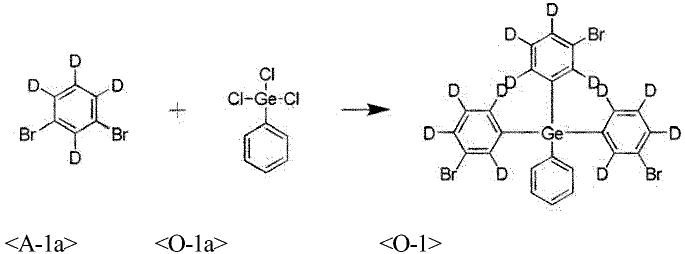

<O-1> was obtained by performing a synthesis in the same manner as in Synthesis Example 1-1, except that <O-1a> was used instead of <A-1b>. (Yield 70%)

### Synthesis Example 15-2: Synthesis of O-2

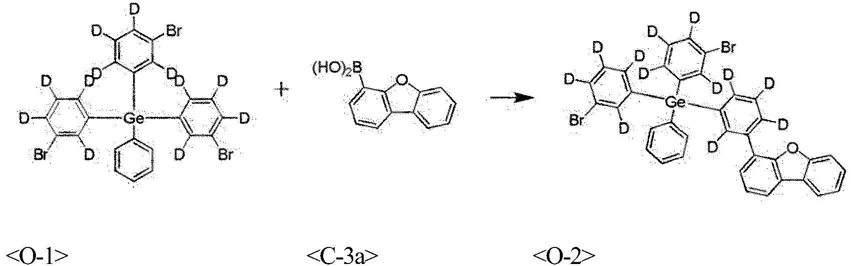

<O-2> was obtained by performing a synthesis in the same manner as in Synthesis Example 1-2, except that <O-1> was used instead of <A-1>, and <C-3a> was used instead of <A-2a>. (Yield 53%)

### Synthesis Example 15-3: Synthesis of O-3

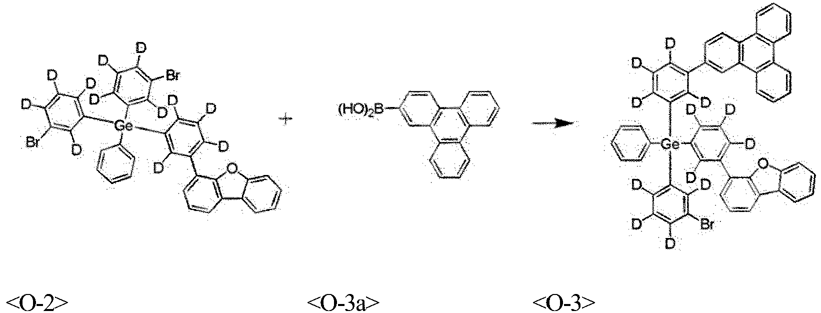

<O-3> was obtained by performing a synthesis in the same manner as in Synthesis Example 1-2, except that <O-2> was used instead of <A-1>, and <O-3a> was used instead of <A-2a>. (Yield 54%)

### Synthesis Example 15-4: Synthesis of O-4

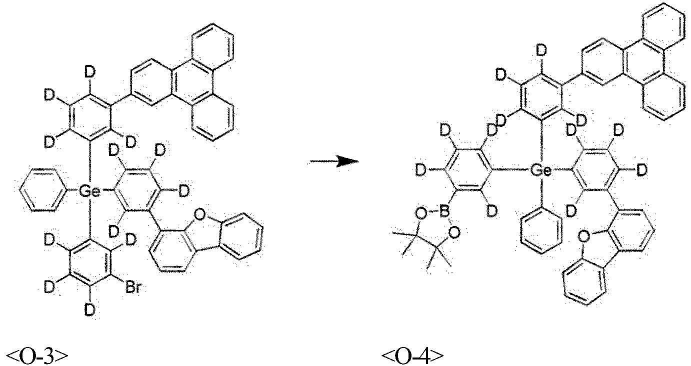

<O-4> was obtained by performing a synthesis in the same manner as in Synthesis Example 1-3, except that <O-3> was used instead of <A-2>. (Yield 78%)

### Synthesis Example 15-5: Synthesis of [ET-15]

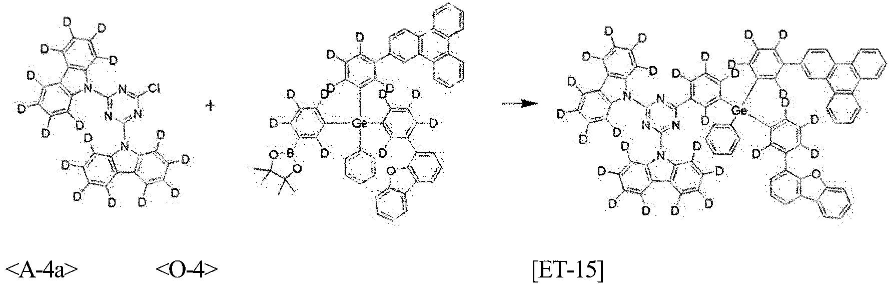

[ET-15] was obtained by performing a synthesis in the same manner as in Synthesis Example 1-4, except that <O-4> was used instead of <A-3>. (Yield 60%)
MS (MALDI-TOF): m/z 1211.51 [M⁺]

### Examples 1 to 24: Manufacture of Organic Light-Emitting Device

ITO glass was patterned to have a light-emitting area of 2 mm×2 mm, and then cleaned. The ITO glass was installed in a vacuum chamber, and the base pressure was set at 1×10⁻⁶ torr. On the ITO, HATCN (50 Å) was deposited as a hole injecting layer, BCFN (600 Å) was deposited as a hole transport layer, and then PBCz (50 Å) was deposited as an electron blocking layer. The first compound and the second compound according to the present invention, which are host compounds, and 12 wt% of a dopant compound PBD were mixed and deposited (350 Å) as a light-emitting layer. Then, mSiTrz (50 Å) was deposited as a hole blocking layer, mSiTrz and Liq (300 Å) were deposited in a ratio of 1:1 as an electron injecting and transport layer, and then Liq (10 Å) was deposited sequentially as an electron injecting layer, and Al (1000 Å), a cathode, was deposited to manufacture an organic light-emitting device. Light-emitting characteristics of the organic light-emitting device were measured at 0.4 mA.

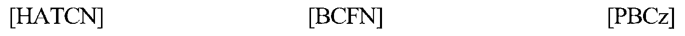

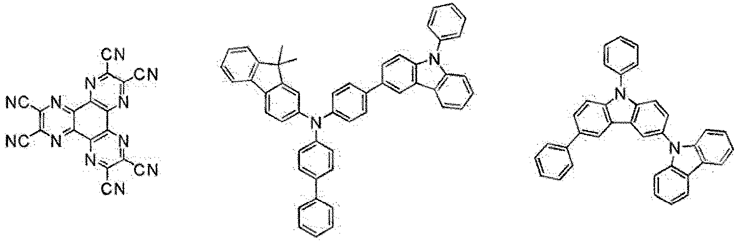

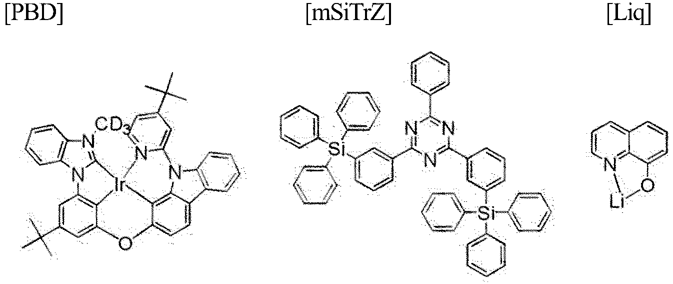

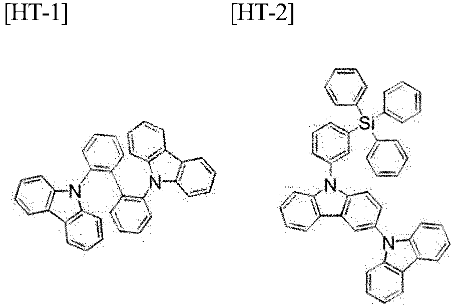

### Comparative Examples 1 to 12

Organic light-emitting devices for Comparative Examples were manufactured in the same manner as in the Examples, except that the following [RH-1] to [RH-6] were used instead of the compounds according to the present invention in the device structures of the Examples as the host compound. Light-emitting characteristics of the organic light-emitting devices were measured at 0.4 mA. The structures of [RH-1] to [RH-6] are as follows.

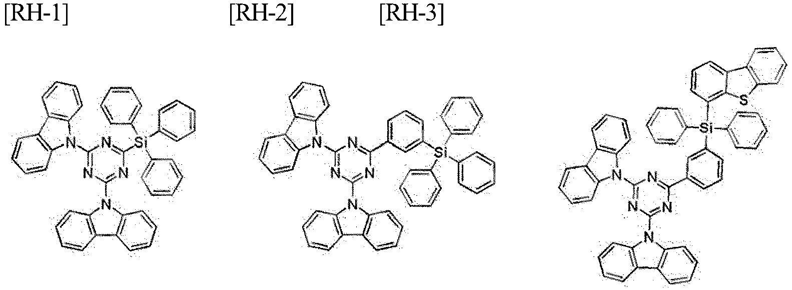

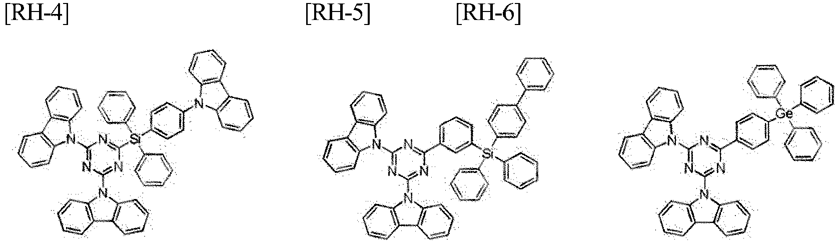

**[Table 1]**

| Classification | First Compound | Second Compound | Driving Voltage (V) | External Quantum Efficiency (EQE, %) | Light-Emitting Color | Lifespan (T95, hr) |
|---|---|---|---|---|---|---|
| Example 1 | ET-1 | HT-1 | 4.5 | 16.6 | Blue | 128 |
| Example 2 | ET-2 | HT-1 | 4.5 | 16.8 | Blue | 155 |
| Example 3 | ET-3 | HT-1 | 4.4 | 17.0 | Blue | 128 |
| Example 4 | ET-4 | HT-1 | 4.5 | 16.6 | Blue | 120 |
| Example 5 | ET-5 | HT-1 | 4.6 | 16.7 | Blue | 157 |
| Example 6 | ET-6 | HT-1 | 4.6 | 16.5 | Blue | 150 |
| Example 7 | ET-7 | HT-1 | 4.6 | 17.3 | Blue | 158 |
| Example 8 | ET-8 | HT-1 | 4.5 | 16.8 | Blue | 150 |
| Example 9 | ET-9 | HT-1 | 4.6 | 16.4 | Blue | 145 |
| Example 10 | ET-10 | HT-1 | 4.6 | 16.5 | Blue | 146 |
| Example 11 | ET-11 | HT-1 | 4.7 | 16.3 | Blue | 118 |
| Example 12 | ET-12 | HT-1 | 4.8 | 16.3 | Blue | 117 |
| Example 13 | ET-13 | HT-1 | 4.7 | 16.6 | Blue | 118 |
| Example 14 | ET-14 | HT-1 | 4.7 | 16.7 | Blue | 116 |
| Example 15 | ET-15 | HT-1 | 4.8 | 16.7 | Blue | 117 |
| Example 16 | ET-2 | HT-2 | 4.6 | 16.7 | Blue | 159 |
| Example 17 | ET-3 | HT-2 | 4.6 | 17.1 | Blue | 132 |
| Example 18 | ET-4 | HT-2 | 4.5 | 16.7 | Blue | 124 |
| Example 19 | ET-7 | HT-2 | 4.6 | 17.3 | Blue | 162 |
| Example 20 | ET-9 | HT-2 | 4.6 | 16.5 | Blue | 149 |
| Example 21 | ET-10 | HT-2 | 4.6 | 16.6 | Blue | 150 |
| Example 22 | ET-13 | HT-2 | 4.7 | 16.7 | Blue | 122 |
| Example 23 | ET-14 | HT-2 | 4.8 | 16.8 | Blue | 120 |
| Example 24 | ET-15 | HT-2 | 4.8 | 16.8 | Blue | 121 |
| Comparative Example 1 | RH-1 | HT-1 | 5.0 | 13.0 | Blue | 56 |
| Comparative Example 2 | RH-2 | HT-1 | 5.1 | 13.6 | Blue | 64 |
| Comparative Example 3 | RH-3 | HT-1 | 5.2 | 13.6 | Blue | 66 |
| Comparative Example 4 | RH-4 | HT-1 | 5.4 | 12.2 | Blue | 50 |
| Comparative Example 5 | RH-5 | HT-1 | 5.2 | 13.5 | Blue | 52 |
| Comparative Example 6 | RH-6 | HT-1 | 5.7 | 13.5 | Blue | 48 |
| Comparative Example 7 | RH-1 | HT-2 | 5.4 | 13.1 | Blue | 60 |
| Comparative Example 8 | RH-2 | HT-2 | 5.5 | 13.7 | Blue | 68 |
| Comparative Example 9 | RH-3 | HT-2 | 5.5 | 13.9 | Blue | 70 |
| Comparative Example 10 | RH-4 | HT-2 | 5.7 | 12.3 | Blue | 54 |
| Comparative Example 11 | RH-5 | HT-2 | 5.4 | 13.5 | Blue | 56 |
| Comparative Example 12 | RH-6 | HT-2 | 6.0 | 13.6 | Blue | 52 |

As shown in [Table 1], the devices employing the compounds according to the present invention as a light-emitting layer host compound in the organic light-emitting device are capable of achieving high-efficiency and long-lifespan organic light-emitting devices with excellent external quantum efficiency and lifespan properties at a low driving voltage compared to the devices (Comparative Examples 1 to 12) employing compounds widely used in the art having structures different from characteristic structures of the compounds according to the present invention.

### Examples 25 to 44: Manufacture of Organic Light-Emitting Device

Organic light-emitting devices were manufactured in the same manner as the organic light-emitting devices used in Examples 1 to 24, except that 0.5 wt% of a dopant compound TBD according to the present invention was additionally mixed and used. Light-emitting characteristics of the organic light-emitting devices were measured at 0.4 mA.

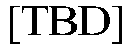

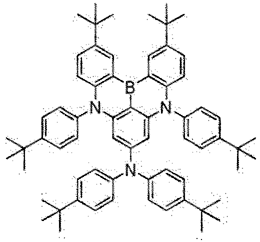

### Comparative Examples 13 to 24

Organic light-emitting devices for Comparative Examples were manufactured in the same manner as in the Examples, except that [RH-1] to [RH-6] were used instead of the compounds according to the present invention in the device structures of the Examples as the host compound. Light-emitting characteristics of the organic light-emitting devices were measured at 0.4 mA.

**[Table 2]**

| Classification | First Compound | Second Compound | Driving Voltage (V) | External Quantum Efficiency (EQE, %) | Light-Emitting Color | Lifespan (T95, hr) |
|---|---|---|---|---|---|---|
| Example 25 | ET-1 | HT-1 | 4.4 | 17.1 | Blue | 138 |
| Example 26 | ET-2 | HT-1 | 4.4 | 17.3 | Blue | 165 |
| Example 27 | ET-3 | HT-1 | 4.3 | 17.5 | Blue | 138 |
| Example 28 | ET-4 | HT-1 | 4.4 | 17.1 | Blue | 130 |
| Example 29 | ET-5 | HT-1 | 4.5 | 17.2 | Blue | 167 |
| Example 30 | ET-6 | HT-1 | 4.6 | 17.0 | Blue | 160 |
| Example 31 | ET-7 | HT-1 | 4.5 | 17.8 | Blue | 168 |
| Example 32 | ET-8 | HT-1 | 4.4 | 17.5 | Blue | 160 |
| Example 33 | ET-9 | HT-1 | 4.5 | 17.1 | Blue | 155 |
| Example 34 | ET-10 | HT-1 | 4.6 | 17.5 | Blue | 156 |
| Example 35 | ET-13 | HT-1 | 4.7 | 16.8 | Blue | 128 |
| Example 36 | ET-14 | HT-1 | 4.8 | 17.1 | Blue | 126 |
| Example 37 | ET-15 | HT-1 | 4.8 | 17.0 | Blue | 127 |
| Example 38 | ET-2 | HT-2 | 4.6 | 17.2 | Blue | 169 |
| Example 39 | ET-3 | HT-2 | 4.6 | 17.6 | Blue | 142 |
| Example 40 | ET-4 | HT-2 | 4.5 | 17.1 | Blue | 134 |
| Example 41 | ET-7 | HT-2 | 4.5 | 17.8 | Blue | 172 |
| Example 42 | ET-9 | HT-2 | 4.5 | 17.0 | Blue | 159 |
| Example 43 | ET-10 | HT-2 | 4.6 | 17.1 | Blue | 160 |
| Example 44 | ET-14 | HT-2 | 4.8 | 17.0 | Blue | 130 |
| Comparative Example 13 | RH-1 | HT-1 | 5.0 | 13.4 | Blue | 66 |
| Comparative Example 14 | RH-2 | HT-1 | 5.0 | 13.9 | Blue | 74 |
| Comparative Example 15 | RH-3 | HT-1 | 5.2 | 14.0 | Blue | 76 |
| Comparative Example 16 | RH-4 | HT-1 | 5.3 | 12.5 | Blue | 60 |
| Comparative Example 17 | RH-5 | HT-1 | 5.2 | 13.7 | Blue | 62 |
| Comparative Example 18 | RH-6 | HT-1 | 5.7 | 13.7 | Blue | 58 |
| Comparative Example 19 | RH-1 | HT-2 | 5.4 | 13.6 | Blue | 70 |
| Comparative Example 20 | RH-2 | HT-2 | 5.4 | 14.1 | Blue | 78 |
| Comparative Example 21 | RH-3 | HT-2 | 5.5 | 14.4 | Blue | 80 |
| Comparative Example 22 | RH-4 | HT-2 | 5.7 | 12.5 | Blue | 64 |
| Comparative Example 23 | RH-5 | HT-2 | 5.6 | 13.7 | Blue | 66 |
| Comparative Example 24 | RH-6 | HT-2 | 6.1 | 13.9 | Blue | 62 |

As shown in [Table 2], the devices employing the compounds according to the present invention as a light-emitting layer host compound in the organic light-emitting device are capable of achieving high-efficiency and long-lifespan organic light-emitting devices with excellent external quantum efficiency and lifespan properties at a low driving voltage compared to the devices (Comparative Examples 13 to 24) employing compounds widely used in the art having structures different from characteristic structures of the compounds according to the present invention.

### [Industrial Applicability]

An organic light-emitting device according to the present invention includes a plurality of host compounds in a light-emitting layer and employs a compound having a characteristic structure as one host material, thereby achieving properties of high efficiency and long lifespan having low-voltage driving, and significantly improved light-emitting efficiency and lifespan. Accordingly, the organic light-emitting device may be industrially utilized not only in lighting devices, but also in various display devices such as flat-panel, flexible and wearable displays, displays for vehicles or aviation, and displays for virtual or augmented reality.

## Claims

1. An organic light-emitting device comprising:
a first electrode;
a second electrode provided opposite to the first electrode; and
an organic layer interposed between the first electrode and the second electrode,
wherein the organic layer includes a light-emitting layer including a host and a dopant,
the host includes a first compound and a second compound, and
the first compound includes at least one organic compound represented by the following [Chemical Formula 1]: 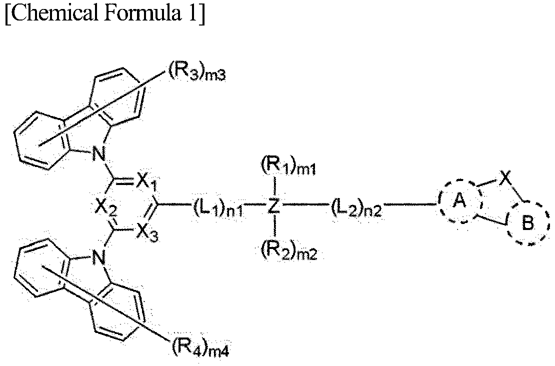
in [Chemical Formula 1],
X₁ to X₃ are the same as or different from each other and each independently N or CR, and at least one of X₁ to X₃ is N;
Z is Si or Ge;
X is any one selected from O, S, NR₅, CR₆R₇, SiR₈R₉ and GeR₁₀R₁₁,
R₁ and R₂ are the same as or different from each other, and each independently any one selected from a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₃₀ heterocycloalkyl group, a substituted or unsubstituted C₂-C₃₀ heteroaryl group, and a substituted or unsubstituted fused cyclic group of C₃-C₃₀ aliphatic ring and C₃-C₃₀ aromatic ring;
R and R₃ to R₁₁ are the same as or different from each other, and each independently any one selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₃₀ aryl group, a substituted or unsubstituted C₃-C₅₀ cycloalkyl group, a substituted or unsubstituted C₂-C₃₀ heterocycloalkyl group, a substituted or unsubstituted C₂-C₃₀ heteroaryl group, a substituted or unsubstituted fused cyclic group of C₃-C₃₀ aliphatic ring and C₃-C₃₀ aromatic ring, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group;
L₁ and L₂ are the same as or different from each other, and each independently any one selected from a substituted or unsubstituted C₆-C₃₀ arylene group, a substituted or unsubstituted C₂-C₃₀ heteroarylene group, and a substituted or unsubstituted fused divalent cyclic group of C₃-C₂₄ aliphatic ring and C₃-C₂₄ aromatic ring;
A and B are the same as or different from each other, and each independently any one selected from a substituted or unsubstituted C₆-C₃₀ aromatic hydrocarbon ring, a substituted or unsubstituted C₃-C₃₀ aliphatic hydrocarbon ring, a substituted or unsubstituted C₂-C₃₀ aromatic heteroring, a substituted or unsubstituted C₂-C₃₀ aliphatic heteroring, and a substituted or unsubstituted fused ring of C₃-C₂₄ aliphatic ring and C₃-C₂₄ aromatic ring;
m₁ and m₂ are each independently an integer of 1 to 3, and when each of m₁ and m₂ is an integer of 2 or greater, the respective R₁s and R₂s are the same as or different from each other;
m₃ and m₄ are each independently an integer of 8, and the respective R₃s and R₄s are the same as or different from each other;
n₁ andn₂ are each independently an integer of 1 to 3, and when each of n₁ andn₂ is an integer of 2 or greater, the respective L₁s and L₂s are the same as or different from each other;
the plurality of adjacent R₃s and R₄s are optionally linked to each other to further form an alicyclic or aromatic monocyclic or polycyclic ring;
R₆ and R₇, R₈ and R₉, and R₁₀ and R₁₁ are optionally linked to each other to further form an alicyclic or aromatic monocyclic or polycyclic ring; and
the 'substituted' in the 'substituted or unsubstituted' in [Chemical Formula 1] means being substituted with one or more substituents selected from the group consisting of deuterium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a fused cyclic group of C₃-C₂₄ aliphatic ring and C₃-C₂₄ aromatic ring, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, and when there are two or more substituents, they are the same as or different from each other, and at least one hydrogen in each of the substituents is optionally substituted with deuterium.

2. The organic light-emitting device of claim 1, wherein the organic compound represented by [Chemical Formula 1] is represented by the following [Chemical Formula 1-1]: 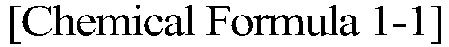 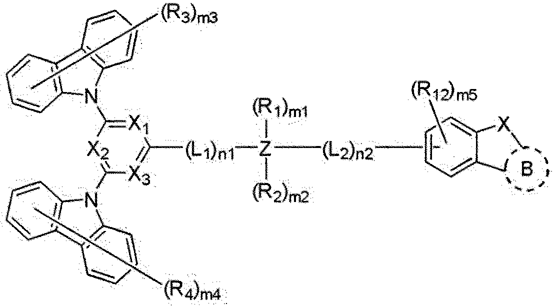 in [Chemical Formula 1-1],
R₁₂s are the same as or different from each other, and each independently any one selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₃₀ aryl group, a substituted or unsubstituted C₃-C₅₀ cycloalkyl group, a substituted or unsubstituted C₂-C₃₀ heterocycloalkyl group, a substituted or unsubstituted C₂-C₅₀ heteroaryl group, a substituted or unsubstituted fused cyclic group of C₃-C₃₀ aliphatic ring and C₅-C₃₀ aromatic ring, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group;
m₅ is an integer of 3, and the respective R₁₂s are the same as or different from each other;
the plurality of adjacent R₁₂s are optionally linked to each other to further form an alicyclic or aromatic monocyclic or polycyclic ring; and
X, X₁ to X₃, Z, R₁ to R₄, L₁, L₂, n₁, n₂, m₁ to m₄, and ring B have the same definitions as in [Chemical Formula 1] of claim 1.

3. The organic light-emitting device of claim 1, wherein L₁ and L₂ are the same as or different from each other, and each independently a substituted or unsubstituted C₆-C₂₀ arylene group.

4. The organic light-emitting device of claim 1, wherein R₁ and R₂ are the same as or different from each other, and each independently any one selected from a substituted or unsubstituted C₆-C₂₀ aryl group, a substituted or unsubstituted C₃-C₂₀ heteroaryl group, and a substituted or unsubstituted fused cyclic group of C₃-C₁₈ aliphatic ring and C₃-C₁₈ aromatic ring.

5. The organic light-emitting device of claim 2, wherein B is a substituted or unsubstituted C₆-C₂₀ aromatic hydrocarbon ring.

6. The organic light-emitting device of claim 1, wherein X₁ to X₃ are all N.

7. The organic light-emitting device of claim 1, wherein at least one hydrogen in the organic compound represented by [Chemical Formula 1] is substituted with deuterium.

8. The organic light-emitting device of claim 7, wherein R₃ and R₄ in [Chemical Formula 1] are all deuterium atoms.

9. The organic light-emitting device of claim 1, wherein X in [Chemical Formula 1] is O or S.

10. The organic light-emitting device of claim 1, wherein [Chemical Formula 1] is any one selected from compounds represented by the following chemical formulae:

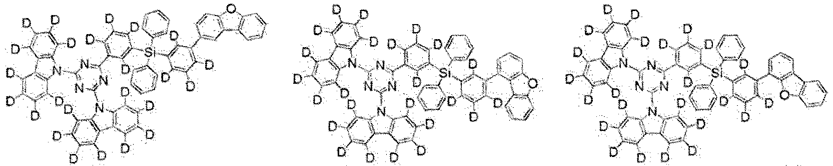

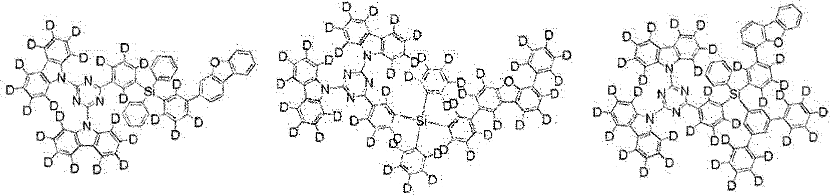

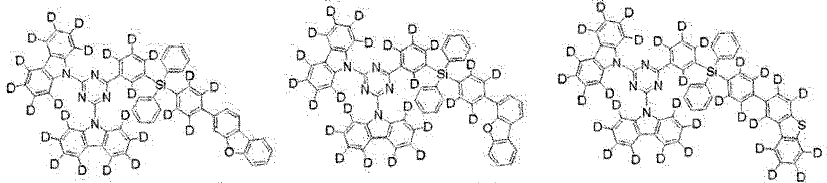

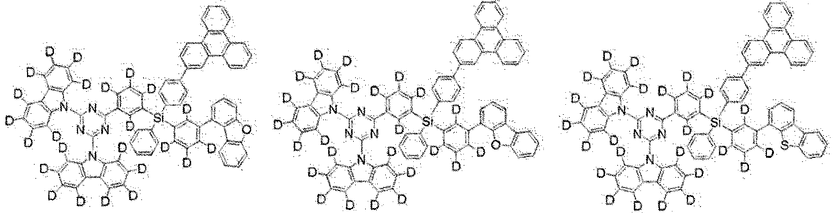

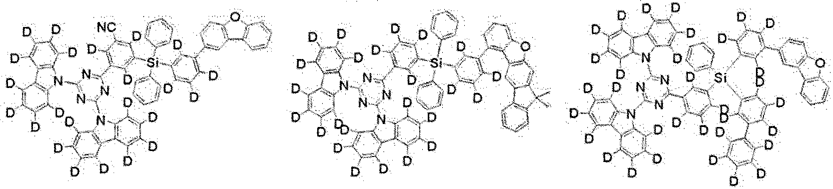

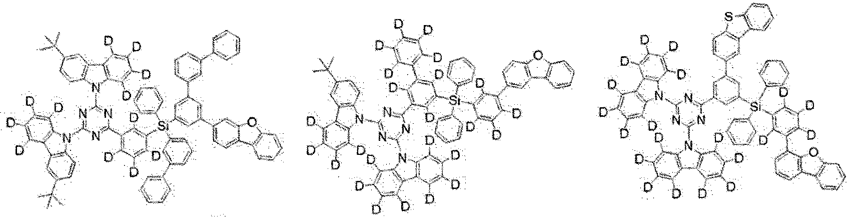

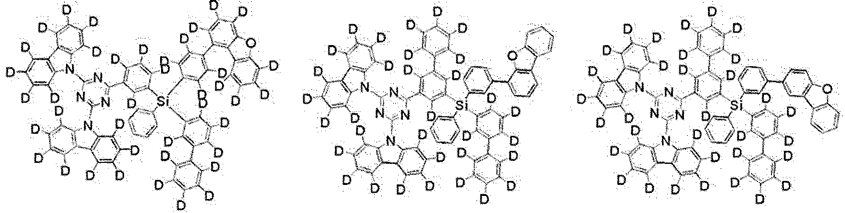

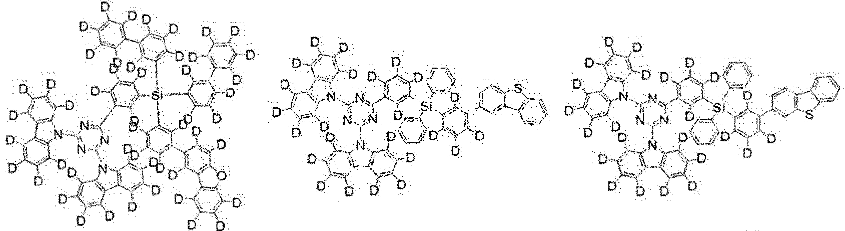

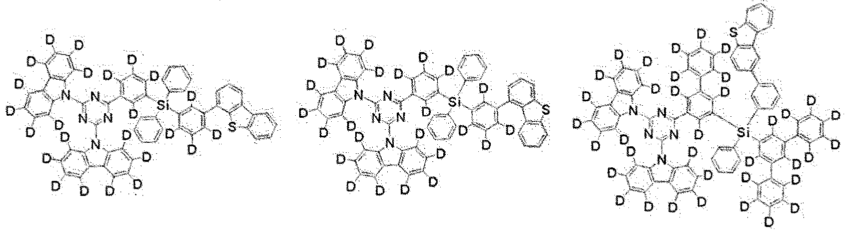

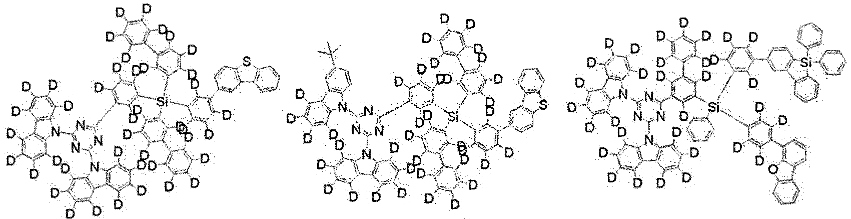

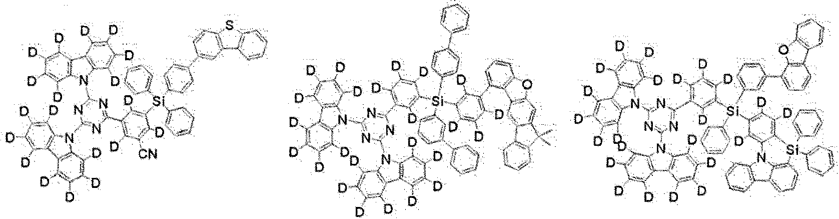

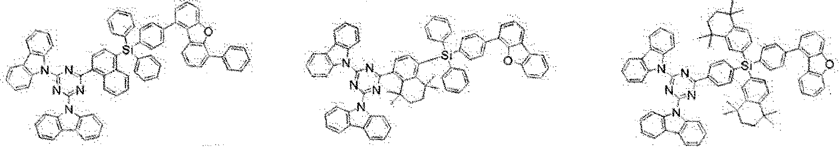

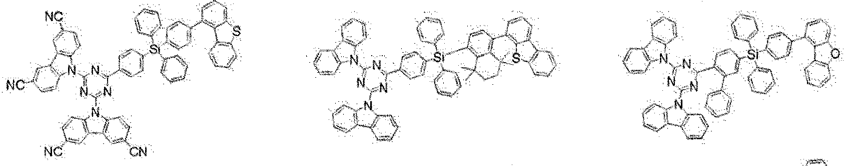

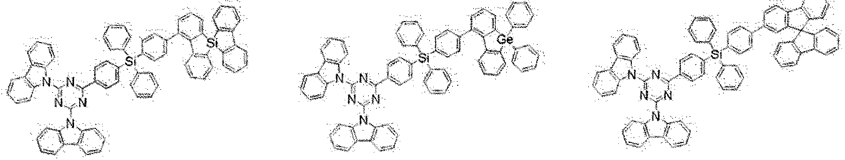

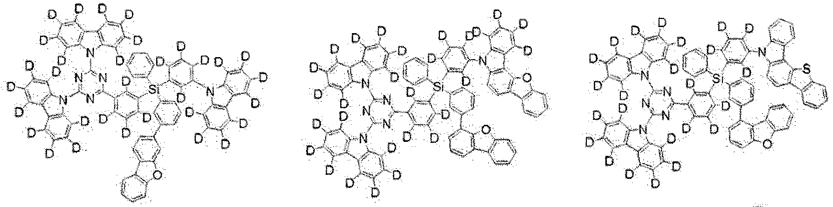

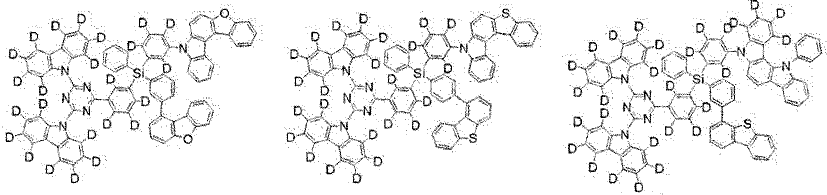

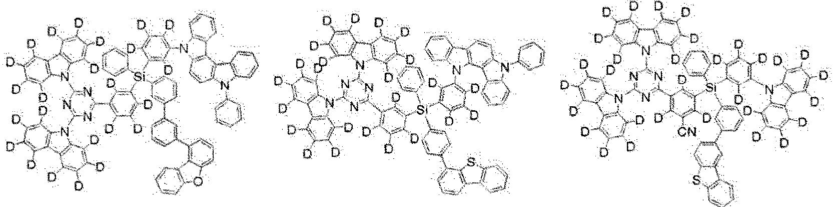

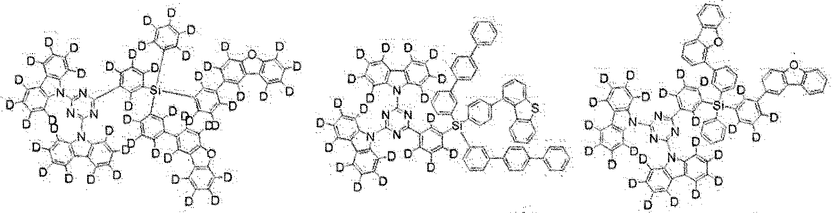

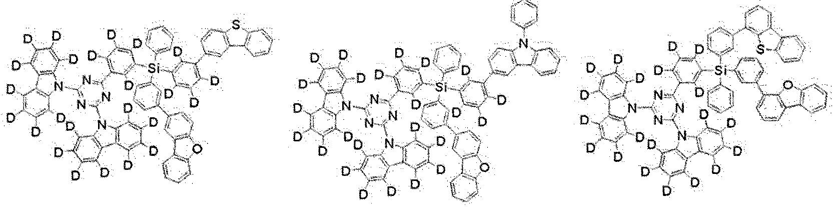

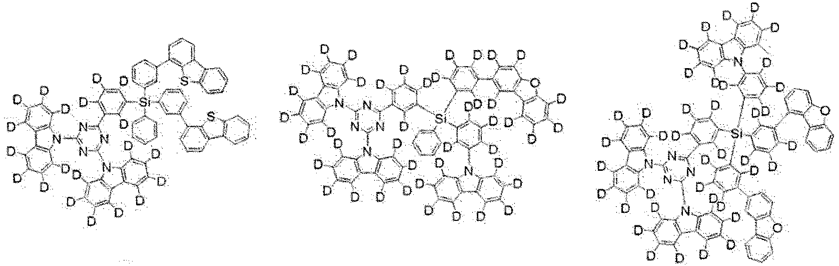

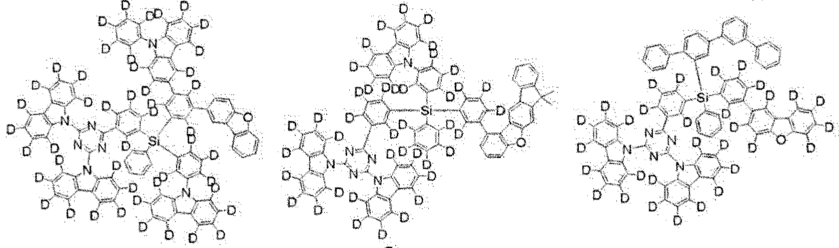

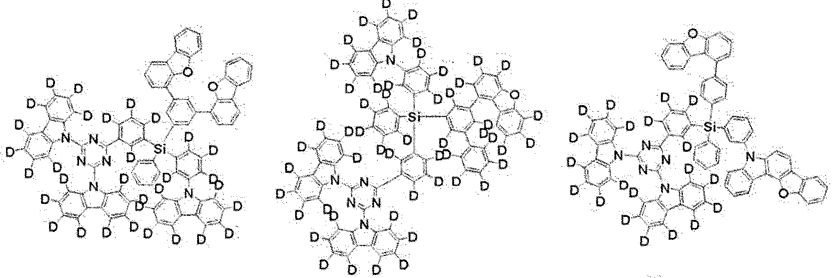

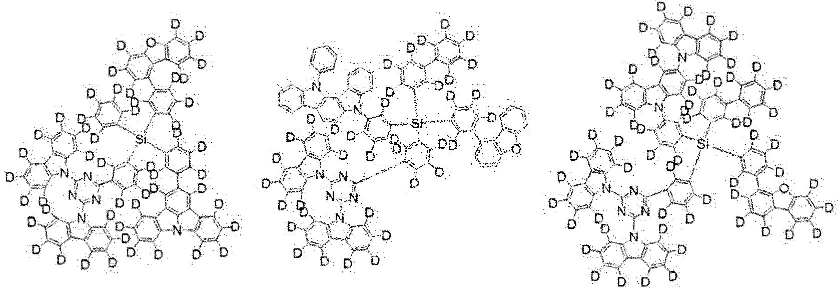

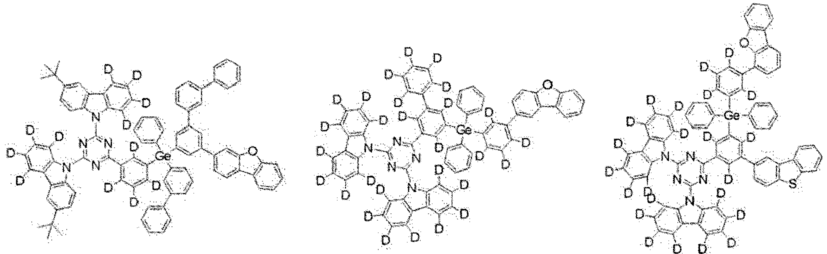

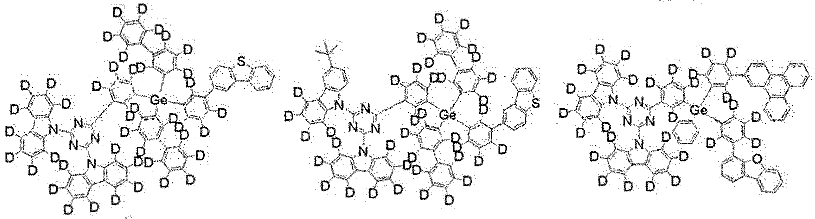

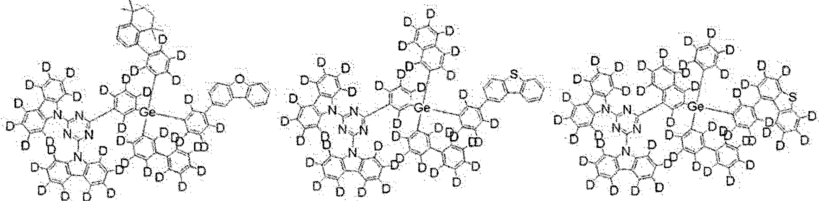

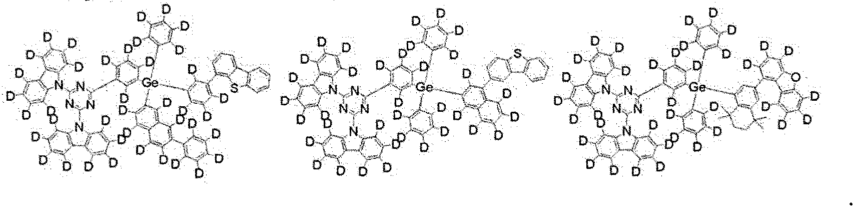

11. The organic light-emitting device of claim 1, wherein the second compound in the host is used by mixing or laminating the first compound represented by [Chemical Formula 1] with at least one other compound.

12. The organic light-emitting device of claim 1, wherein the organic compound represented by [Chemical Formula 1] used as the first compound in the host is used in a blue phosphorescent host.

13. The organic light-emitting device of claim 1, wherein the dopant includes at least one organometallic compound.

14. The organic light-emitting device of claim 13, wherein, in addition to the organometallic compound, a polycyclic compound represented by the following [Chemical Formula 2] is mixed or laminated and used: 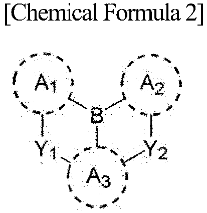 in [Chemical Formula 2],
Y₁ and Y₂ are the same as or different from each other, and each independently any one selected from O, S, NR₁₃, CR₁₄R₁₅, SiR₁₆R₁₇ and GeR₁₈R₁₉;
A₁ to A₃ are the same as or different from each other, and each independently any one selected from a substituted or unsubstituted C₆-C₃₀ aromatic hydrocarbon ring, a substituted or unsubstituted C₃-C₃₀ aliphatic hydrocarbon ring, a substituted or unsubstituted C₂-C₃₀ aromatic heteroring, a substituted or unsubstituted C₂-C₃₀ aliphatic heteroring, and a substituted or unsubstituted fused ring of C₃-C₂₄ aliphatic ring and C₃-C₂₄ aromatic ring;
R₁₃ to R₁₉ are the same as or different from each other, and each independently any one selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₃₀ aryl group, a substituted or unsubstituted C₃-C₅₀ cycloalkyl group, a substituted or unsubstituted C₂-C₃₀ heterocycloalkyl group, a substituted or unsubstituted C₂-C₃₀ heteroaryl group, a substituted or unsubstituted fused cyclic group of C₃-C₃₀ aliphatic ring and C₃-C₃₀ aromatic ring, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group;
R₁₃ to R₁₉ are optionally linked to the rings A₁ to A₃ to further form an alicyclic or aromatic monocyclic or polycyclic ring;
R₁₄ and R₁₃, R₁₆ and R₁₇, and R₁₈ and R₁₉ are each optionally linked to each other to further form an alicyclic or aromatic monocyclic or polycyclic ring; and
the 'substituted' in the 'substituted or unsubstituted' in [Chemical Formula 2] means being substituted with one or more substituents selected from the group consisting of deuterium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a fused cyclic group of C₃-C₂₄ aliphatic ring and C₃-C₂₄ aromatic ring, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, and when there are two or more substituents, they are the same as or different from each other, and at least one hydrogen in each of the substituents is optionally substituted with deuterium.

15. The organic light-emitting device of claim 10, which is used in any one device selected from flat-panel display devices; flexible display devices; monochromatic or white flat-panel lighting devices; monochromatic or white flexible lighting devices; display devices for vehicles and aviation; and display devices for virtual or augmented reality.
